# EUROPEAN PATENT APPLICATION

(11) **EP 4 366 486 A1**
(43) Date of publication of application: **08.05.2024**
(21) Application number: 23207499.7
(22) Date of filing: 02.11.2023
(51) Int. Cl.: H10K 59/122, H10K 59/123, H10K 59/131

(54) **DISPLAY PANEL**

(30) Priority: 04.11.2022 KR 20220145944
(71) Applicant: Samsung Display Co., Ltd., Gyeonggi-Do (KR)
(72) Inventor: PARK, Juchan, Yongin-si (KR); KO, Yoomin, Yongin-si (KR); CHOI, Chung Sock, Yongin-si (KR); KIM, Sunho, Yongin-si (KR); KIM, Hyewon, Yongin-si (KR); LEE, Pilsuk, Yongin-si (KR); HONG, Sungjin, Yongin-si (KR)
(74) Representative: Marks & Clerk LLP

(57) **Abstract**

A display panel includes a display area and a peripheral area adjacent to the display area and includes a transistor, a light emitting device including a first electrode and a second electrode disposed on the first electrode and electrically connected to the transistor, a separator, a power line at least partially disposed in the peripheral area, and a separation conductive layer including a first portion disposed on the separator and a second portion disposed in the peripheral area. An outer side surface of the separator includes a connection area, and an interior angle between the connection area and a lower surface of the separator is smaller than an interior angle between an inner side surface of the separator and the lower surface of the separator.

## Description

### BACKGROUND

### 1. Technical Field

The disclosure relates to a display panel. By way of example, the disclosure relates to a display panel with improved reliability.

### 2. Description of the Related Art

Multimedia electronic devices, such as televisions, mobile phones, tablet computers, computers, navigation devices, and game devices, include a display panel displaying an image.

The display panel may include light emitting devices and a pixel driver to drive the light emitting devices. The light emitting devices included in the display panel emit a light in response to electrical characteristics controlled by the pixel driver and generate the image. Research on connections between the light emitting devices and the pixel driver is in progress to improve a reliability of the display panel.

It is to be understood that this background of the technology section is, in part, intended to provide useful background for understanding the technology. However, this background of the technology section may also include ideas, concepts, or recognitions that were not part of what was known or appreciated by those skilled in the pertinent art prior to a corresponding effective filing date of the subject matter disclosed herein.

### SUMMARY

The disclosure provides a display panel with improved afterimage defects, lifespan, electrical reliability, and resolution.

The disclosure provides a display panel including a light emitting device with improved electrical reliability and with reduced defects in display quality.

The technical objectives to be achieved by the disclosure are not limited to those described herein, and other technical objectives that are not mentioned herein would be clearly understood by a person skilled in the art from the description of the disclosure.

Embodiments provide a display panel that includes a display area and a peripheral area adjacent to the display area and includes at least one transistor disposed on a base layer; a light emitting device including a first electrode and a second electrode disposed on the first electrode and electrically connected to the at least one transistor; a separator; a power line at least partially disposed in the peripheral area; and a separation conductive layer including a first portion disposed on the separator and a second portion disposed in the peripheral area. An outer side surface of the separator includes a connection area, an interior angle between the connection area and a lower surface of the separator is smaller than an interior angle between an inner side surface of the separator and the lower surface of the separator, and the first portion disposed on the connection area is connected to the second portion.

The second portion may be electrically connected to the power line, the power line receives (*e.g*. is configured to receive) a constant voltage, and the first portion receives (*e.g.* is configured to receive) the constant voltage via the second portion.

The second portion extends from a portion of the first portion, which is disposed on the connection area, to a direction away from the separator.

The power line may be electrically connected to the first electrode and provides (*e.g*. is configured to provide) a first power supply voltage to the first electrode.

A portion of the power line electrically connects the first electrode, and another portion of the power line electrically connects the second portion of the separation conductive layer.

The power line may be electrically connected to the at least one transistor and provides (*e.g*. is configured to provide) a second power supply voltage to the at least one transistor.

The separator may include an inner side portion disposed in the display area and an outer portion surrounding the inner side portion and disposed in the peripheral area, the outer portion may include a first area and a second area each extending in a first direction and spaced apart from each other in a second direction intersecting the first direction and a third area and a fourth area each extending in the second direction and spaced apart from each other in the first direction.

The first area, the second area, the third area, and the fourth area may include the connection area.

The outer side surface of the separator may further include a separation area; an interior angle between the separation area and the lower surface of the separator is greater than an interior angle between the connection area and the lower surface of the separator; and the first portion disposed on the separation area is separated from the second portion in a cross-section.

A portion of the first area, the second area, the third area and the fourth area may include the connection area, and the other portion of the first area, the second area, the third area and the fourth area may include the separation area.

The connection area may include first sub-connection areas and second sub-connection areas, the separation area may include a first main separation area, a second main separation area, first sub-separation areas, and second sub-separation areas, the third area and fourth area include the first main separation area and the second main separation area, respectively, the first area may include the first sub-connection areas alternately disposed with the first sub-separation areas, and the second area may include the second sub-connection areas alternately disposed with the second sub-separation areas.

The connection area may include a main connection area; first sub-connection areas; and second sub-connection areas; the separation area may include a main separation area; first sub-separation areas; and second sub-separation areas; the third area may include the main connection area; the fourth area may include the main separation area; the first area may include the first sub-connection areas alternately disposed with the first sub-separation areas; and the second area may include the second sub-connection areas alternately disposed with the second sub-separation areas.

The first portion and the separator may have substantially a same shape in a plan view.

The interior angle between the inner side surface of the separator and the lower surface of the separator and the interior angle between the connection area and the lower surface of the separator may be about equal to or greater than about 90 degrees.

The interior angle between the inner side surface of the separator and the lower surface of the separator may be about equal to or greater than about 90 degrees, and the interior angle between the connection area and the lower surface of the separator may be less than about 90 degrees.

The power line may correspond to one of a first power line receiving (*e.g*. configured to receive) a first power supply voltage and a second power line receiving (*e.g*. configured to receive) a second power supply voltage. The first power line may include a first wiring part disposed at an upper side of the display area and including patterns disposed in the first direction, a second wiring part disposed at a lower side of the display area and including patterns disposed in the first direction, a third wiring part disposed at a left side of the display area and extending in the second direction intersecting the first direction, and a fourth wiring part disposed at a right side of the display area and extending in the second direction.

The second power line may include a fifth wiring part disposed at the upper side of the display area and including patterns surrounding the patterns of the first wiring part, respectively, and a sixth wiring part disposed at the lower side of the display area and including patterns surrounding the patterns of the second wiring part, respectively.

The display panel further may include a connection wiring electrically connecting the transistor to the light emitting device. The connection wiring may include an emission connection part electrically connected to the light emitting device and a driver connection part electrically connected to the transistor.

The connection wiring may include a first layer, a second layer disposed on the first layer, and a third layer disposed on the second layer, a side surface of the third layer protrudes outward from a side surface of the second layer, and the second electrode contacts the side surface of the second layer.

The separation conductive layer may be spaced apart from the second electrode and the separation conductive layer and the second electrode may include a same material.

The separator may include an inner side portion disposed in the display area and an outer portion surrounding the inner side portion and disposed in the peripheral area, and the outer portion may include a first extension portion surrounding the display area, a second extension portion surrounding the first extension portion and including the outer side surface, and bridge portions each connecting the first extension portion and the second extension portion.

The second extension portion may include a first area and a second area each extending in the first direction and spaced apart from each other in the second direction intersecting the first direction and third area and the fourth area each extending in the second direction and spaced apart from each other in the first direction.

Each of the bridge portions may extend in a direction perpendicular to an extension direction in which the first extension portion extends or an oblique direction of the extension direction.

Each of the bridge portions has a straight line shape or a curved line shape in a plan view.

The outer portion further may include a third extension portion disposed between the first extension portion and the second extension portion, and the bridge portions include a first bridge portion connecting the first extension portion and the third extension portion and a second bridge portion connecting the second extension portion and the third extension portion.

The display panel further may include an additional separation pattern layer surrounded by the first extension portion and the second extension portion and the bridge portions connected to the first extension portion and the second extension portion, spaced apart from the separation conductive layer, and the additional separation pattern layer and the second electrode including a same material.

At least some of the above and other embodiments of the invention are set out in the claims.

According to the above, as the constant voltage is applied to the separation conductive layer disposed on the separator, which disconnects electrodes included in adjacent pixels, the electrical influences of the separation conductive layer on the light emitting device is reduced. Thus, an error in the driving current of the light emitting device is reduced, and the electrical reliability of the light emitting device is improved. Accordingly, the display panel with reduced defects in display quality is provided. The electrical influences of the separation conductive layer on the input sensing layer is also reduced, and the sensing layer with improved electrical reliability is provided. Thus, the sensing reliability of the display panel is improved.

According to the above, as the separator may include outer patterns and bridge patterns connecting the outer patterns, the process reliability of the separator is improved, and the occurrence of defects is reduced. Accordingly, the electrode of the pixels and the power line are prevented from being electrically connected to each other.

### BRIEF DESCRIPTION OF THE DRAWINGS

The above and other advantages will become readily apparent by reference to the following detailed description when considered in conjunction with the accompanying drawings wherein:
FIG. 1 is a block diagram of a display device according to an embodiment;
FIGS. 2A and 2B are schematic diagrams of equivalent circuits of pixels according to an embodiment;
FIGS. 3A and 3B are schematic plan views of display panels according to embodiments;
FIGS. 4A to 4C are enlarged schematic plan views of areas of a display area according to an embodiment;
FIG. 5A is an enlarged schematic cross-sectional view of a display panel taken along line I-I' of FIG. 4B according to an embodiment;
FIG. 5B is an enlarged schematic cross-sectional view of an area AA' of FIG. 5A according to an embodiment;
FIG. 5C is an enlarged schematic cross-sectional view taken along line I-I' of FIG. 4B according to an embodiment;
FIG. 6 is a schematic plan view of components of a display panel according to an embodiment;
FIGS. 7A and 7B are enlarged schematic plan views of an area BB' of FIG. 6 according to an embodiment;
FIG. 8A is an enlarged schematic cross-sectional view of a display panel taken along line II-II' of FIG. 6 according to an embodiment;
FIG. 8B is an enlarged schematic cross-sectional view of a display panel taken along line III-III' of FIG. 6 according to an embodiment;
FIG. 8C is an enlarged schematic cross-sectional view of an area CC' of FIGS. 8A and 8B according to an embodiment;
FIG. 8D is an enlarged schematic cross-sectional view of an area CC' of FIGS. 8A and 8B according to an embodiment;
FIG. 9 is a schematic plan view of a display panel according to an embodiment;
FIG. 10A is a schematic plan view of a display panel according to an embodiment;
FIG. 10B is an enlarged schematic cross-sectional view of a display panel taken along line IV-IV' of FIG. 10A according to an embodiment;
FIG. 11 is a schematic plan view of a display panel according to an embodiment;
FIG. 12 is a schematic plan view of a display panel according to an embodiment;
FIG. 13 is a schematic plan view of a display panel according to an embodiment;
FIGS. 14A and 14B are enlarged schematic plan views of an area DD' of FIG. 13 according to an embodiment;
FIG. 15 is an enlarged schematic cross-sectional view of a display panel taken along line V-V' of FIG. 13 according to an embodiment;
FIG. 16 is an enlarged schematic plan view of components of a display panel according to an embodiment; and
FIGS. 17A to 17C are enlarged schematic plan views of components of a display panel according to embodiments.

### DETAILED DESCRIPTION OF THE EMBODIMENTS

The disclosure will now be described more fully hereinafter with reference to the accompanying drawings, in which embodiments are shown. This disclosure may, however, be embodied in different forms and should not be construed as limited to the embodiments set forth herein. Rather, these embodiments are provided so that this disclosure will be thorough and complete, and will fully convey the scope of the disclosure to those skilled in the art.

In the disclosure, it will be understood that when an element (or area, layer, or portion) is referred to as being "on", "connected to" or "coupled to" another element or layer, it can be directly on, connected or coupled to the other element or layer or intervening elements or layers may be present.

Like numerals refer to like elements throughout. In the drawings, the thickness, ratio, and dimension of components are exaggerated for effective description of the technical content.

In the specification and the claims, the term "and/or" is intended to include any combination of the terms "and" and "or" for the purpose of its meaning and interpretation. For example, "A and/or B" may be understood to mean "A, B, or A and B. " The terms "and" and "or" may be used in the conjunctive or disjunctive sense and may be understood to be equivalent to "and/or."

It will be understood that, although the terms first, second, etc. may be used herein to describe various elements, these elements should not be limited by these terms. These terms are only used to distinguish one element from another element. Thus, a first element discussed below could be termed a second element without departing from the teachings of the disclosure.

As used herein, the singular forms, "a", "an" and "the" are intended to include the plural forms as well, unless the context clearly indicates otherwise.

Spatially relative terms, such as "beneath", "below", "lower", "above", "upper" and the like, may be used herein for ease of description to describe one element or feature's relationship to other elements or features as shown in the figures.

It will be further understood that the terms "comprises," "comprising," "includes," and/or "including,", "has," "have," and/or "having," and variations thereof when used in this specification, specify the presence of stated features, integers, steps, operations, elements, components, and/or groups thereof, but do not preclude the presence or addition of one or more other features, integers, steps, operations, elements, components, and/or groups thereof.

The term "part" or "unit" as used herein is intended to mean a software component or a hardware component that performs a specific function. The hardware component may include, for example, a field-programmable gate array (FPGA) or an application-specific integrated circuit (ASIC). The software component may refer to an executable code and/or data used by the executable code in an addressable storage medium. Thus, the software components may be, for example, object-oriented software components, class components, and task components, and may include processes, functions, attributes, procedures, subroutines, segments of program code, drivers, firmware, micro codes, circuits, data, a database, data structures, tables, arrays, or variables.

For the purposes of this disclosure, the phrase "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z. The term "overlap" or "overlapped" means that a first object may be above or below or to a side of a second object, and vice versa.

Additionally, the term "overlap" may include layer, stack, face or facing, extending over, covering, or partly covering or any other suitable term as would be appreciated and understood by those of ordinary skill in the art. The expression "not overlap" may include meaning such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Unless otherwise defined or implied herein, all terms including technical and scientific terms used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, embodiments will be described with reference to accompanying drawings.

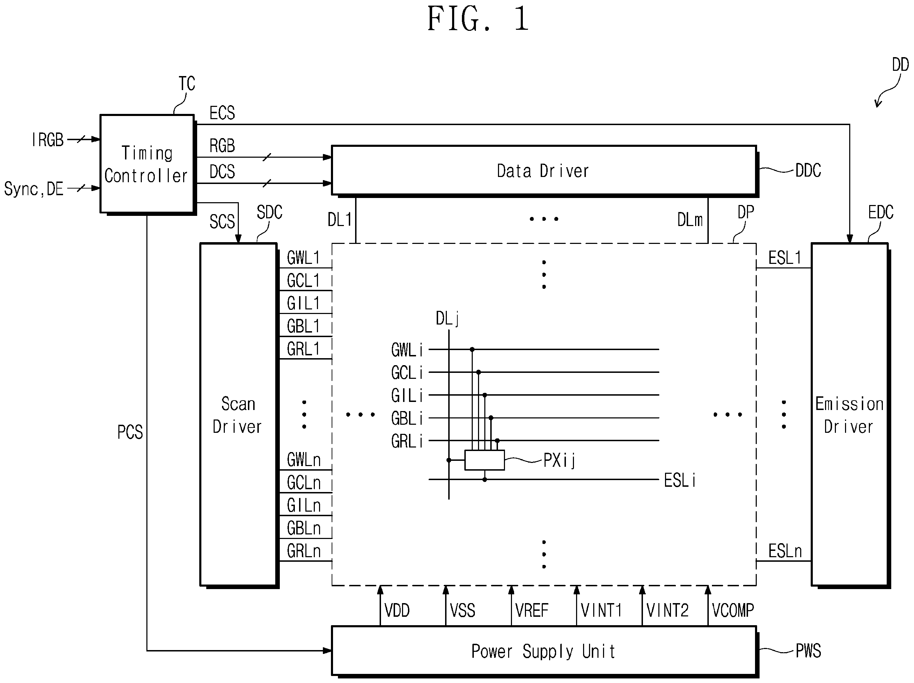

FIG. 1 is a block diagram of a display device DD according to an embodiment.

Referring to FIG. 1, the display device DD may include a timing controller TC, a panel driver, and a display panel DP. The display panel DP may be a light-emitting type display panel. The light-emitting type display panel DP may be an organic light emitting display panel or a quantum dot light emitting display panel. The panel driver may include a scan driver SDC, an emission driver EDC, and a data driver DDC.

The display panel DP may include scan lines GWL1 to GWLn, GCL1 to GCLn, GIL1 to GILn, GBL1 to GBLn, and GRL1 to GRLn, emission lines ESL1 to ESLn, and data lines DL1 to DLm. The display panel DP may include pixels connected to the scan lines GWL1 to GWLn, GCL1 to GCLn, GIL1 to GILn, GBL1 to GBLn, and GRL1 to GRLn, the emission lines ESL1 to ESLn, and the data lines DL1 to DLm. Each of "m" and "n" is an integer number greater than 1.

As an example, a pixel PXij (each of "i" and "j" is an integer number greater than 0) positioned to correspond to an i-th horizontal line (or an i-th pixel row) and a j-th vertical line (or a j-th pixel column) may be connected to an i-th first scan line GWLi, an i-th second scan line GCLi, an i-th third scan line GILi, an i-th fourth scan line GBLi, an i-th fifth scan line GRLi, a j-th data line DLj, and an i-th emission line ESLi.

The pixel PXij may include transistors and capacitors. The pixel PXij may receive a first power supply voltage (or a first driving voltage) VDD, a second power supply voltage (or a second driving voltage) VSS, a third power supply voltage (or a reference voltage) VREF, a fourth power supply voltage (or a first initialization voltage) VINT1, a fifth power supply voltage (or a second initialization voltage) VINT2, and a sixth power supply voltage (or a compensation voltage) VCOMP from a power supply unit PWS.

The first power supply voltage VDD and the second power supply voltage VSS may have a voltage value set to allow a current to flow through a light emitting device. As an example, the first power supply voltage VDD may be set to have a voltage level higher than that of the second power supply voltage VSS.

The third power supply voltage VREF may be a voltage to initialize a gate of a driving transistor included in the pixel PXij. The third power supply voltage VREF may be used to implement a selectable grayscale using a difference in voltage between the third power supply voltage VREF and a data signal. To this end, the third power supply voltage VREF may be set to a selectable voltage within a voltage range of the data signal.

The fourth power supply voltage VINT1 may be used to initialize a storage capacitor included in the pixel PXij. The fourth power supply voltage VINT1 may be set to a voltage level lower than that of the third power supply voltage VREF. As an example, the fourth power supply voltage VINT1 may be set to a voltage level lower than a difference between the third power supply voltage VREF and a threshold voltage (Vth) of the driving transistor. As an example, the fourth power supply voltage VINT1 may have a voltage level equal to or greater than about 4 volts and equal to or smaller than about 12 volts. When the fourth power supply voltage VINT1 is set to an electric potential equal to or greater than about 4 volts, characteristics of an N-type transistor may be readily overcome, however, the disclosure should not be limited thereto or thereby.

The fifth power supply voltage VINT2 may be a direct current voltage. The fifth power supply voltage VINT2 may be used to initialize a cathode of the light emitting device included in the pixel PXij.

The sixth power supply voltage VCOMP may provide a selectable current to the driving transistor when the threshold voltage of the driving transistor is compensated for.

Each of the fifth and sixth power supply voltages VINT2 and VCOMP may be set to a voltage level lower than the first power supply voltage VDD or the fourth power supply voltage VINT1 or may be set to a voltage level similar to or same as the third power supply voltage VREF, however, they should not be limited thereto or thereby. Each of the fifth and sixth power supply voltages VINT2 and VCOMP may be set to a voltage level similar to or the same as the first power supply voltage VDD.

FIG. 1 shows a structure in which all the first, second, third, fourth, fifth, and sixth power supply voltages VDD, VSS, VREF, VINT1, VINT2, and VCOMP are provided from the power supply unit PWS, however, the disclosure should not be limited thereto or thereby. As an example, both of the first power supply voltage VDD and the second power supply voltage VSS may be provided regardless of the structure of the pixel PXij, and at least one of the third power supply voltage VREF, the fourth power supply voltage VINT1, the fifth power supply voltage VINT2, and the sixth power supply voltage VCOMP may not be provided according to the structure of the pixel PXij.

According to the disclosure, signal lines connected to the pixel PXij may be designed in various ways by taking into account the circuit structure of the pixel PXij.

The scan driver SDC may receive a first control signal SCS from the timing controller TC and may provide a scan signal to the first scan lines GWL1 to GWLn, the second scan lines GCL1 to GCLn, the third scan lines GIL1 to GILn, the fourth scan lines GBL1 to GBLn, and the fifth scan lines GRL1 to GRLn in response to the first control signal SCS.

The scan signal may be set to a gate-on-voltage to allow the transistors to be turned on in response to the scan signal.

As an example, the scan signal provided to a PMOS (P-channel metal oxide semiconductor) transistor may be set to a logic low level, and the scan signal provided to an NMOS (N-channel metal oxide semiconductor) transistor may be set to a logic high level. Hereinafter, the expression "the scan signal is provided" may mean that the scan signal is provided to the transistor, which is controlled thereby, with a logic level that turns on the transistor.

For the convenience of explanation, FIG. 1 shows one scan driver SDC, however, the disclosure should not be limited thereto or thereby. According to an embodiment, the display device DD may include multiple scan drivers to provide the scan signal to the first scan lines GWL1 to GWLn, the second scan lines GCL1 to GCLn, the third scan lines GIL1 to GILn, the fourth scan lines GBL1 to GBLn, and the fifth scan lines GRL1 to GRLn, respectively.

The emission driver EDC may provide emission signals to the emission lines ESL1 to ESLn in response to a second control signal ECS. As an example, the emission signals may be sequentially provided to the emission lines ESL1 to ESLn.

Each transistor connected to the emission lines ESL1 to ESLn may be the NMOS transistor. The emission signals provided to the emission lines ESL1 to ESLn may have a gate on voltage, for example, the logic high level. The transistors may be turned on when receiving the emission signal and may be turned off in other cases.

The second control signal ECS may include an emission start signal and clock signals, and the emission driver EDC may be implemented by a shift register that sequentially shifts the emission start signal with a pulse shape using the clock signals to sequentially generate and output the emission signals with a pulse shape.

The data driver DDC may receive a third control signal DCS and image data RGB from the timing controller TC. The data driver DDC may convert the image data RGB in a digital form to analog data signals. The data driver DDC may provide the data signal to the data lines DL1 to DLm in response to the third control signal DCS.

The third control signal DCS may include a data enable signal, a horizontal start signal, and a data clock signal to indicate an output of an effective data signal. As an example, the data driver DDC may include a shift register that shifts the horizontal start signal in synchronization with the data clock signal to generate a sampling signal, a latch that latches the image data RGB in response to the sampling signal, a digital-to-analog converter (or a decoder) that converts the latched image data, for example, data in the digital form to data signals in the analog form, and buffers (or amplifiers) that output the data signals to the data lines DL1 to DLm.

The power supply unit PWS may provide the first power supply voltage VDD, the second power supply voltage VSS, and the third power supply voltage VREF to the display panel DP to drive the pixel PXij. The power supply unit PWS may further provide at least one voltage of the fourth power supply voltage VINT1, the fifth power supply voltage VINT2, and the sixth power supply voltage VCOMP to the display panel DP.

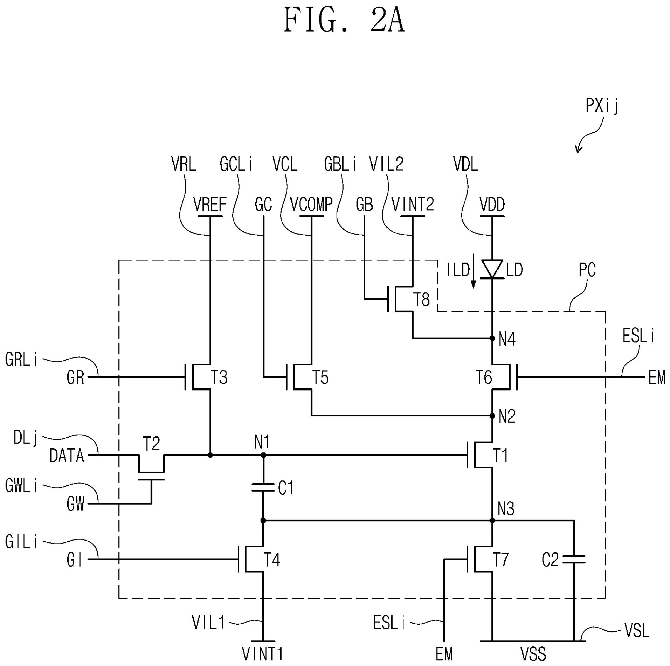

As an example, the power supply unit PWS may provide the first power supply voltage VDD, the second power supply voltage VSS, the third power supply voltage VREF, the fourth power supply voltage VINT1, the fifth power supply voltage VINT2, and the sixth power supply voltage VCOMP to the display panel DP respectively via a first power line VDL (or a first driving voltage line, refer to FIG. 2A), a second power line VSL (or a second driving voltage line, refer to FIG. 2A), a third power line VRL (or a reference voltage line, refer to FIG. 2A), a fourth power line VIL1 (or a first initialization voltage line, refer to FIG. 2A), a fifth power line VIL2 (or a second initialization voltage line, refer to FIG. 2A), and a sixth power line VCL (or a compensation voltage line, refer to FIG. 2A), which are shown in FIG. 2A.

The power supply unit PWS may be implemented by a power management IC (PMIC), however, the disclosure should not be limited thereto or thereby.

The timing controller TC may generate the first control signal SCS, the second control signal ECS, the third control signal DCS, and a fourth control signal PCS based on input image data IRGB, a synchronization signal Sync, for example, a vertical synchronization signal, a horizontal synchronization signal, etc., a data enable signal DE, and a clock signal. The first control signal SCS may be applied to the scan driver SDC, the second control signal ECS may be applied to the emission driver EDC, the third control signal DCS may be applied to the data driver DDC, and the fourth control signal PCS may be applied to the power supply unit PWS. The timing controller TC may rearrange the input image data IRGB to correspond to an arrangement of the pixel in the display panel DP and may generate the image data RGB (or frame data).

At least one of the scan driver SDC, the emission driver EDC, the data driver DDC, the power supply unit PWS, and the timing controller TC may be formed in the display panel DP or may be connected to the display panel DP after being implemented in an integrated circuit. At least two of the scan driver SDC, the emission driver EDC, the data driver DDC, the power supply unit PWS, and the timing controller TC may be implemented in a single integrated circuit. As an example, the data driver DDC and the timing controller TC may be provided in the single integrated circuit.

In the above descriptions, the display device DD is described with reference to FIG. 1, however, the display device DD should not be limited thereto or thereby. Signal lines may be added or omitted depending on the structure of the pixels. A connection relationship between one pixel and the signal lines may be changed. In a case where one of the signal lines is omitted, the omitted signal line may be replaced with another signal line.

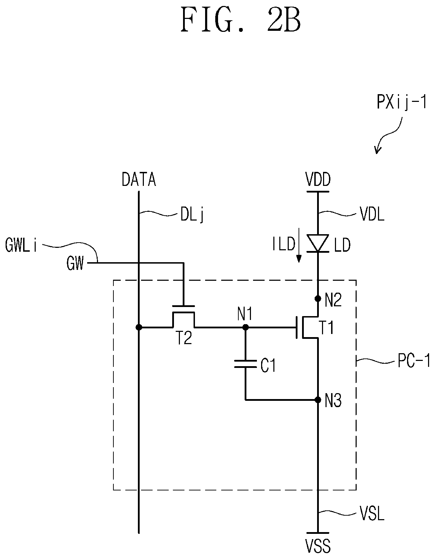

FIGS. 2A and 2B are schematic diagrams of equivalent circuits of pixels PXij and PXij-1 according to embodiments. FIGS. 2A and 2B show the equivalent circuit diagrams of the pixels PXij and PXij-1, which are connected to the i-th first scan line GWLi (hereinafter, referred to as a first scan line) and the j-th data line DLj (hereinafter, referred to as a data line).

Referring to FIG. 2A, the pixel PXij may include a light emitting device LD and a pixel driver PC. The light emitting device LD may be connected to the first power line VDL and the pixel driver PC.

The pixel driver PC may be connected to the scan lines GWLi, GCLi, GILi, GBLi, and GRLi, the data line DLj, the emission line ESLi, and the power lines VDL, VSL, VIL1, VIL2, VRL, and VCL. The pixel driver PC may include first, second, third, fourth, fifth, sixth, seventh, and eighth transistors T1, T2, T3, T4, T5, T6, T7, and T8, a first capacitor C1, and a second capacitor C2. Hereinafter, each of the first, second, third, fourth, fifth, sixth, seventh, and eighth transistors T1, T2, T3, T4, T5, T6, T7, and T8 will be described as the N-type transistor, however, the disclosure should not be limited thereto or thereby. According to an embodiment, some or a number of the first to eighth transistors T1 to T8 may be the N-type transistor, and the other of the first to eighth transistors T1 to T8 may be the P-type transistor, or each of the first to eighth transistors T1 to T8 may be a P-type transistor, and the disclosure should not be particularly limited.

A gate of the first transistor T1 may be connected to a first node N1. A first electrode of the first transistor T1 may be connected to a second node N2, and a second electrode of the first transistor T1 may be connected to a third node N3. The first transistor T1 may be a driving transistor. The first transistor T1 may control a driving current ILD flowing from the first power line VDL to the second power line VSL via the light emitting device LD in response to a voltage of the first node N1. The first driving voltage VDD may be set to a voltage with an electric potential higher than the second driving voltage VSS.

In the disclosure, the expression "the transistor is electrically connected to the signal line (or the transistor is electrically connected to the transistor)" may mean that a source, drain, or gate of the transistor is integral with the signal line (or a source, drain, or gate of the transistor) or connected to the signal line (or the transistor) via a connection electrode.

The second transistor T2 may include a gate connected to the first scan line GWLi, a first electrode connected to the data line DLj, and a second electrode connected to the first node N1. The second transistor T2 may provide a data signal DATA to the first node N1 in response to a write scan signal GW applied thereto via the first scan line GWLi. The second transistor T2 may be a switching transistor. The second transistor T2 may be turned on when the write scan signal GW is applied to the first scan line GWLi, and thus, the data line DLj may be electrically connected to the first node N1.

The third transistor T3 may be connected between the first node N1 and the third power line VRL. A first electrode of the third transistor T3 may receive the reference voltage VREF via the third power line VRL, and a second electrode of the third transistor T3 may be connected to the first node N1. In an embodiment, a gate of the third transistor T3 may receive a reset scan signal GR via the i-th fifth scan line GRLi (hereinafter, referred to as a fifth scan line). The third transistor T3 may be turned on when the reset scan signal GR is applied to the fifth scan line GRLi and may provide the reference voltage VREF to the first node N1.

The fourth transistor T4 may be connected between the third node N3 and the fourth power line VIL1. A first electrode of the fourth transistor T4 may be connected to the third node N3, and a second electrode of the fourth transistor T4 may be connected to the fourth power line VIL1 through which the first initialization voltage VINT1 is provided. A gate of the fourth transistor T4 may receive an initialization scan signal GI via the i-th third scan line GILi (hereinafter, referred to as a third scan line). The fourth transistor T4 may be turned on when the initialization scan signal GI is provided to the third scan line GILi and may provide the first initialization voltage VINT1 to the third node N3.

The fifth transistor T5 may be connected between the sixth power line VCL and the second node N2. A first electrode of the fifth transistor T5 may receive the compensation voltage VCOMP via the sixth power line VCL, and a second electrode of the fifth transistor T5 may be connected to the second node N2 to be electrically connected to the first electrode of the first transistor T1. A gate of the fifth transistor T5 may receive a compensation scan signal GC via the i-th second scan line GCLi (hereinafter, referred to as a second scan line). The fifth transistor T5 may be turned on when the compensation scan signal GC is provided to the second scan line GCLi and may provide the compensation voltage VCOMP to the second node N2, and thus, the threshold voltage (Vth) of the first transistor T1 may be compensated for during a compensation period.

The sixth transistor T6 may be connected between the first transistor T1 and the light emitting device LD. In detail, a gate of the sixth transistor T6 may receive the emission signal EM via the i-th emission line ESLi (hereinafter, referred to as an emission line). A first electrode of the sixth transistor T6 may be connected to the cathode of the light emitting device LD via a fourth node N4, and a second electrode of the sixth transistor T6 may be connected to the first electrode of the first transistor T1 via the second node N2. The sixth transistor T6 may be referred to as a first emission control transistor. The sixth transistor T6 may be turned on when the emission signal EM is provided to the emission line ESLi, and thus, the light emitting device LD may be electrically connected to the first transistor T1.

The seventh transistor T7 may be connected between the second power line VSL and the third node N3. A first electrode of the seventh transistor T7 may be connected to the second electrode of the first transistor T1 via the third node N3, and a second electrode of the seventh transistor T7 may receive the second driving voltage VSS via the second power line VSL. A gate of the seventh transistor T7 may be electrically connected to the emission line ESLi. The seventh transistor T7 may be referred to as a second emission control transistor. The seventh transistor T7 may be turned on when the emission signal EM is provided to the emission line ESLi, and thus, the first electrode of the first transistor T1 may be electrically connected to the second power line VSL.

According to an embodiment, the sixth transistor T6 and the seventh transistor T7 are connected to the same emission line ESLi and are turned on in response to the same emission signal EM, however, this is an example. According to an embodiment, the sixth transistor T6 and the seventh transistor T7 may be independently turned on in response to different signals distinguished from each other. According to an embodiment, one of the sixth transistor T6 and the seventh transistor T7 may be omitted from the pixel driver PC.

The eighth transistor T8 may be connected between the fifth power line VIL2 and the fourth node N4. For example, the eighth transistor T8 may include a gate connected to the i-th fourth scan line GBLi (hereinafter, referred to as a fourth scan line), a first electrode connected to the fifth power line VIL2, and a second electrode connected to the fourth node N4. The eighth transistor T8 may provide the second initialization voltage VINT2 to the fourth node N4 corresponding to the cathode of the light emitting device LD in response to a black scan signal GB applied thereto via the fourth scan line GBLi. The cathode of the light emitting device LD may be initialized by the second initialization voltage VINT2.

According to an embodiment, some or a number of the second, third, fourth, fifth, sixth, seventh, and eighth transistors T2, T3, T4, T5, T6, T7, and T8 may be substantially simultaneously turned on in response to the same scan signal. As an example, the eighth transistor T8 and the fifth transistor T5 may be substantially simultaneously turned on in response to the same scan signal. As an example, the eighth transistor T8 and the fifth transistor T5 may be operated in response to the same compensation scan signal GC. Since the eighth transistor T8 and the fifth transistor T5 are turned on and off in response to the same compensation scan signal GC, the eighth transistor T8 and the fifth transistor T5 may be substantially simultaneously turned on and off. The second scan line GCLi and the fourth scan line GBLi may be substantially provided as a single scan line. Accordingly, the initialization of the cathode of the light emitting device LD and the compensation of the threshold voltage of the first transistor T1 may be performed at the same timing, however, the disclosure should not be limited thereto or thereby.

According to the disclosure, the initialization of the cathode of the light emitting device LD and the compensation of the threshold voltage of the first transistor T1 may be performed in response to the same power supply voltage. As an example, the sixth power line VCL and the fifth power line VIL2 may be substantially provided as a single power line. The initialization operation of the cathode and the compensation operation of the driving transistor may be performed using one power supply voltage, and thus, a design for the drivers may be simplified. However, this is an example, and the disclosure should not be particularly limited.

The first capacitor C1 may be disposed between the first node N1 and the third node N3. The first capacitor C1 may be charged with a voltage corresponding to a difference between the voltage of the first node N1 and the voltage of the third node N3. The first capacitor C1 may be referred to as a storage capacitor.

The second capacitor C2 may be disposed between the third node N3 and the second power line VSL. For example, one electrode of the second capacitor C2 may be connected to the second power line VSL receiving the second driving voltage VSS, and the other electrode of the second capacitor C2 may be connected to the third node N3. The second capacitor C2 may be charged with electric charges corresponding to a difference in voltage between the second power supply voltage VSS and the third node N3. The second capacitor C2 may be referred to as a hold capacitor. The second capacitor C2 may have a higher storage capacity compared with the first capacitor C1. Accordingly, the second capacitor C2 may reduce a variation in voltage of the third node N3 according to a variation in voltage of the first node N1.

In an embodiment, the light emitting device LD may be connected to the pixel driver PC via the fourth node N4. The light emitting device LD may include an anode connected to the first power line VDL and the cathode opposite to the anode. In an embodiment, the light emitting device LD may be connected to the pixel driver PC through the cathode thereof. For example, according to the pixel PXij, a connection node at which the light emitting device LD is connected to the pixel driver PC may be the fourth node N4, and the fourth node N4 may correspond to a connection node between the first electrode of the sixth transistor T6 and the cathode of the light emitting device LD.

Accordingly, an electric potential of the fourth node N4 may correspond to an electric potential of the cathode of the light emitting device LD. For example, the anode of the light emitting device LD may be connected to the first power line VDL, the first driving voltage VDD that is a constant voltage may be applied to the anode, the cathode may be electrically connected to the first transistor T1 via the sixth transistor T6, and the electric potential of the cathode may be controlled. For example, an electric potential of the second node N2 corresponding to a source of the first transistor T1 may not be directly affected by characteristics of the light emitting device LD. Accordingly, even though the characteristics of the light emitting device LD are deteriorated due to a lifespan of the light emitting device LD, an influence of the deterioration in the characteristics of the light emitting device LD on a gate-source voltage (Vgs) of the transistors constituting the pixel driver PC, especially the driving transistor, may be reduced. For example, since a range of change in an amount of current due to the deterioration of the light emitting device may be reduced, an image retention defect of the display panel according to the increase in usage time may be reduced, and a lifespan of the display panel may be improved.

As shown in FIG. 2B, the pixel PXij-1 may include a pixel driver PC-1 including two transistors T1 and T2 and one capacitor C1. The pixel driver PC-1 may be connected to a light emitting device LD, a first scan line GWLi, a data line DLj, and a second power line VSL. The pixel driver PC-1 shown in FIG. 2B may correspond to a circuit configuration obtained by removing the third to eighth transistors T3 to T8 and one capacitor C2 from the pixel driver PC shown in FIG. 2A.

Each of the first and second transistors T1 and T2 may be an N-type transistor or a P-type transistor. In an embodiment, each of the first and second transistors T1 and T2 will be described as the N-type transistor.

The first transistor T1 may include a gate connected to a first node N1, a first electrode connected to a second node N2, and a second electrode connected to a third node N3. The second node N2 may be connected to a first power line VDL, and the third node N3 may be connected to the second power line VSL. The first transistor T1 may be connected to the light emitting device LD via the second node N2 and may be connected to the second power line VSL via the third node N3. The first transistor T1 may be a driving transistor.

The second transistor T2 may include a gate receiving a write scan signal GW via a first scan line GWLi, a first electrode connected to the data line DLj, and a second electrode connected to the first node N1. The second transistor T2 may provide a data signal DATA to the first node N1 in response to the write scan signal GW applied thereto via the first scan line GWLi.

The capacitor C1 may include an electrode connected to the first node N1 and an electrode connected to the third node N3. The capacitor C1 may be charged with the data signal DATA applied to the first node N1.

The light emitting device LD may include an anode and a cathode. In an embodiment, the anode of the light emitting device LD may be connected to the first power line VDL, and the cathode of the light emitting device LD may be connected to the pixel driver PC-1 via the second node N2. In an embodiment, the cathode of the light emitting device LD may be connected to the first transistor T1. The light emitting device LD may emit a light in response to an amount of current flowing through the first transistor T1 of the pixel driver PC-1.

The second node N2 at which the cathode of the light emitting device LD is connected to the pixel driver PC-1 may correspond to a drain of the first transistor T1. The light emitting device LD may be connected to the pixel driver PC-1 via the second node N2. For example, in the pixel PXij-1 shown in FIG. 2B, a connection node at which the light emitting device LD is connected to the pixel driver PC-1 may be the second node N2, and the second node N2 may correspond to a connection node between the first electrode of the first transistor T1 and the cathode of the light emitting device LD.

For example, in the case where the driving transistor is the N-type transistor, the display panel may prevent a variation in a gate-source voltage of the first transistor T1, which is caused by the light emitting device LD. Accordingly, the range of change in the amount of current due to deterioration of the light emitting device LD may be reduced, the image retention defect of the display panel according to the increase in usage time may be reduced, and the lifespan of the display panel may be improved.

FIGS. 2A and 2B show the circuit configurations of the pixel drivers PC and PC-1 according to embodiments of the disclosure. In the disclosure, the display panel should not be particularly limited, and the number and arrangement of the transistors and the number and arrangement of the capacitors may be designed in various ways as long as a circuit is connected to the cathode of the light emitting device LD.

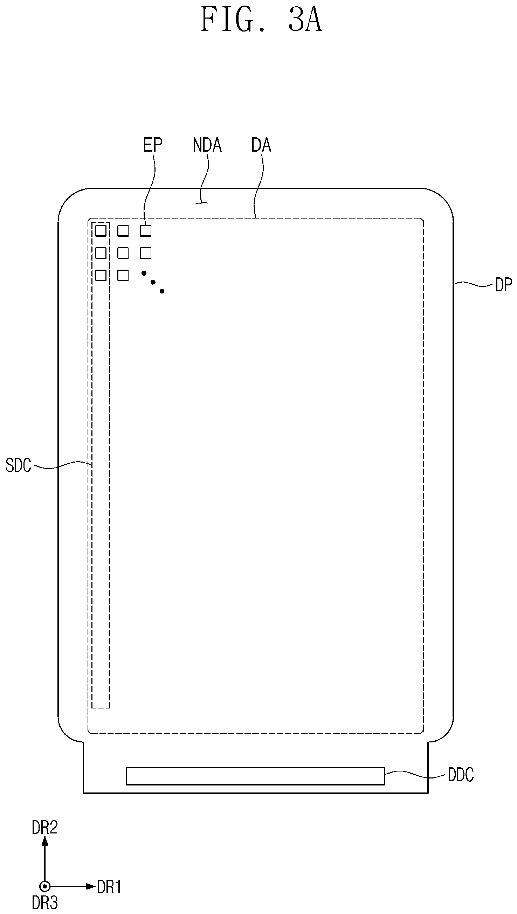

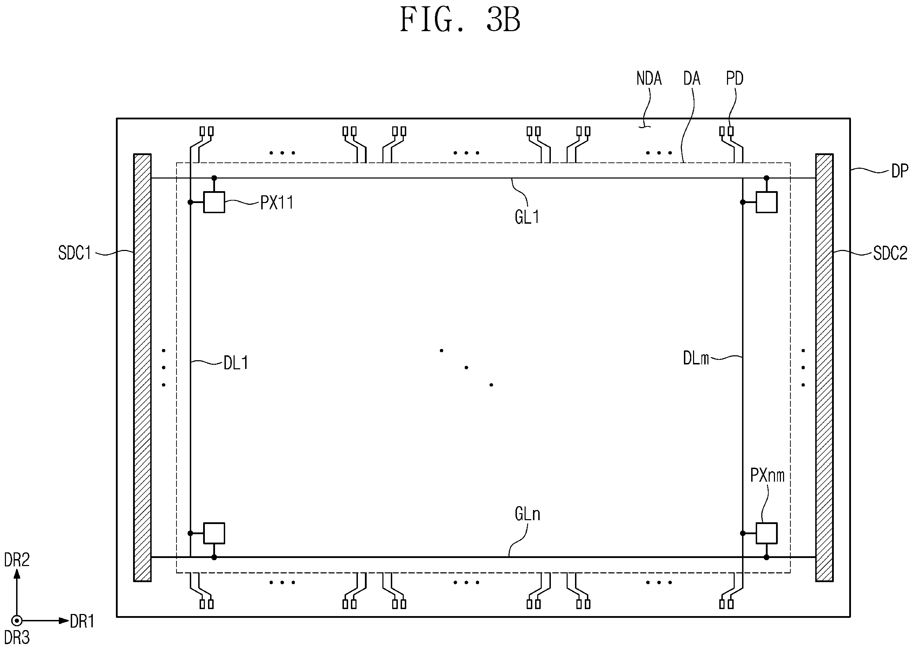

FIGS. 3A and 3B are schematic plan views of display panels DP according to embodiments. In FIGS. 3A and 3B, components may be omitted, and for the convenience of explanation, components mounted on the display panel DP are not omitted. Hereinafter, the disclosure will be described with reference to FIGS. 3A and 3B. Referring to FIG. 3A, the display panel DP includes a display area DA and a peripheral area NDA. The display area DA includes light emitting parts EP.

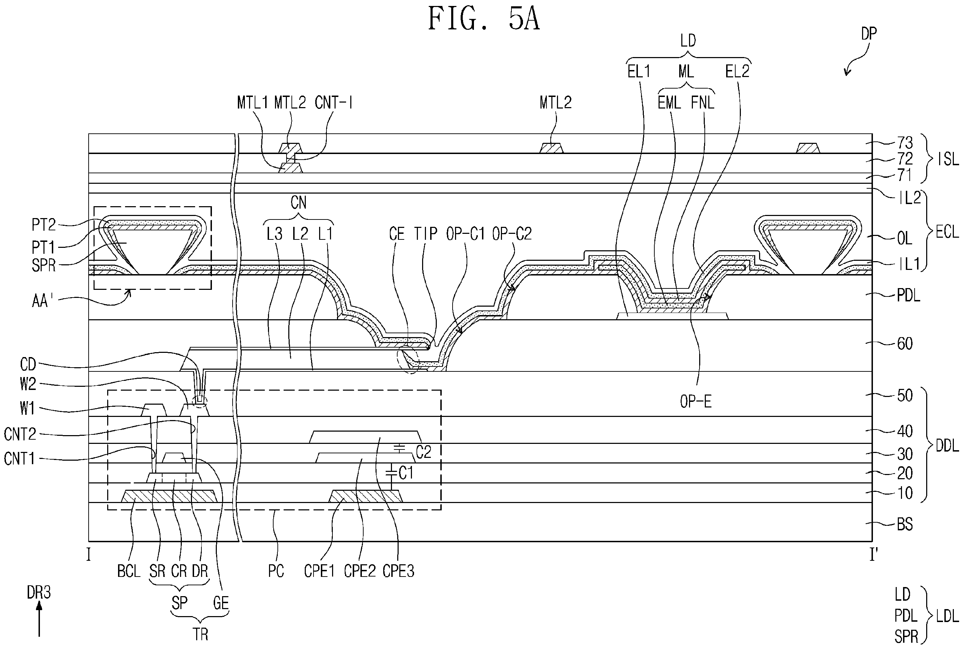

The light emitting parts EP may be areas where the pixels emit the light. In detail, each of the light emitting parts EP may correspond to a light emitting opening OP-E (refer to FIG. 5A) described later.

The peripheral area NDA may be defined adjacent to the display area DA. In an embodiment, the peripheral area NDA may have a shape surrounding an edge of the display area DA, however, this is an example. According to an embodiment, the peripheral area NDA may be defined adjacent to one side or a side of the display area DA or may be omitted, but should not be particularly limited.

In an embodiment, a scan driver SDC and a data driver DDC may be mounted on the display panel DP. The scan driver SDC may be disposed in the display area DA, and the data driver DDC may be disposed in the peripheral area NDA. The scan driver SDC may overlap at least some or a number of the light emitting parts EP arranged (or disposed) in the display area DA in a plan view. As the scan driver SDC is disposed in the display area DA, a size of the peripheral area NDA may be reduced compared with that of a display panel in which a scan driver is disposed in a peripheral area, and thus, a narrow bezel of the display device DD (refer to FIG. 1) may be readily implemented. However, the disclosure should not be limited thereto or thereby, and the scan driver SDC may be disposed in the peripheral area NDA.

Different from the scan driver SDC shown in FIG. 3A, the scan driver SDC may be provided in two parts distinguished from each other. The two scan drivers SDC may be respectively disposed at left and right sides of the display area DA to be spaced apart from each other. According to an embodiment, three or more scan drivers SDC may be employed, and the number of the scan drivers SDC should not be particularly limited.

FIG. 3A shows a representative example of the display device DD (refer to FIG. 1), however, the data driver DDC may be disposed in the display area DA. When the data driver DDC is disposed in the display area DA, some or a number of the light emitting parts EP arranged in the display area DA may overlap the data driver DDC when viewed in the plan view.

The data driver DDC may be provided in a separate driving chip independently formed from the display panel DP and may be connected to the display panel DP, however, this is an example. According to an embodiment, the data driver DDC may be formed through the same process as the scan driver SDC to form the display panel DP, and it should not be limited thereto or thereby.

Referring to FIG. 3B, the display device DD (refer to FIG. 1) may include the display panel DP having long sides extending in a first direction DR1. In an embodiment, the display device DD (refer to FIG. 1) may include scan drivers SDC1 and SDC2. The scan drivers SDC1 and SDC2 may include a first scan driver SDC1 and a second scan driver SDC2, which are spaced apart from each other in the first direction DR1.

The first scan driver SDC1 may be connected to some or a number of scan lines of scan lines GL1 to GLn, and the second scan driver SDC2 may be connected to the other scan lines among the scan lines GL1 to GLn. As an example, the first scan driver SDC1 may be connected to odd-numbered scan lines among the scan lines GL1 to GLn, and the second scan driver SDC2 may be connected to even-numbered scan lines among the scan lines GL1 to GLn.

For the convenience of explanation, FIG. 3B shows pads PD of data lines DL1 to DLm. The pads PD may be placed at ends of the data lines DL1 to DLm. The data lines DL1 to DLm may be connected to the data driver DDC (refer to FIG. 3A) via the pads PD.

According to the disclosure, the pads PD may be arranged in areas of the peripheral area NDA, which are spaced apart from each other with the display area DA interposed therebetween. As an example, some or a number of pads among the pads PD may be arranged in an upper portion of the display panel DP, which is adjacent to a first scan line GL1 among the scan lines GL1 to GLn, and the other pads among the pads PD may be arranged in a lower portion of the display panel DP, which is adjacent to the last scan line GLn among the scan lines GL1 to GLn. In an embodiment, pads, which are connected to odd-numbered data lines among the pads PD may be arranged in the upper portion, and pads among the pads PD, which are connected to even-numbered data lines, among the pads PD may be arranged in the lower portion. Although not shown in figures, the data driver may include three upper data drivers connected to the pads PD arranged in the upper portion and three lower data drivers connected to the pads PD arranged in the lower portion, however, these are examples. According to an embodiment, the pads PD may be connected to two data drivers arranged in the upper and lower portions. According to an embodiment, the pads PD may be arranged in one side portion or a side portion and may be connected to a single data driver, however, the disclosure should not be particularly limited. FIG. 3B also includes pixels PX11 and PXnm and appropriate connections thereto.

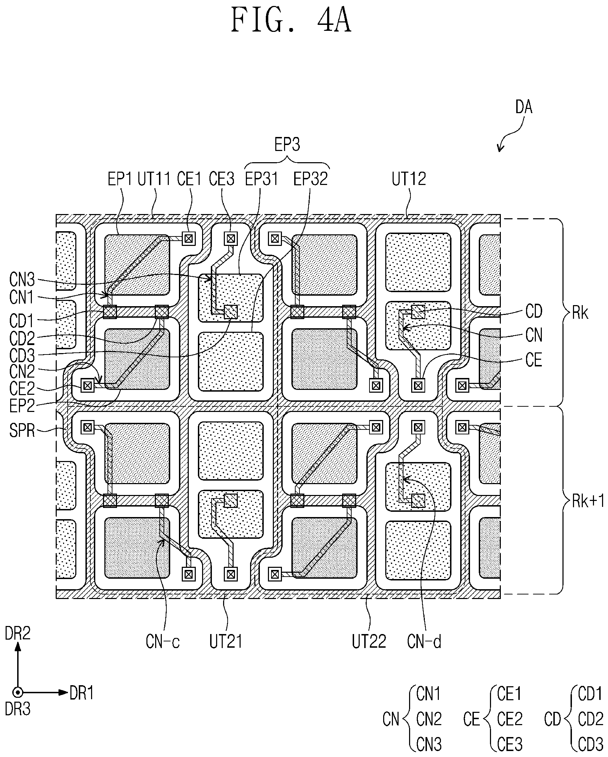

FIGS. 4A to 4C are enlarged schematic plan views of some or a number of areas of the display area according to an embodiment. FIG. 4A shows light emitting units UT11, UT12, UT21, and UT22 arranged in two rows by two columns. The light emitting parts arranged in a first row Rk may include light emitting parts constituting the light emitting unit UT11 arranged in a first row and a first column and the light emitting unit UT12 arranged in the first row and a second column, and the light emitting parts arranged in a second row Rk+1 may include light emitting parts constituting the light emitting unit UT21 arranged in a second row and the first column and the light emitting unit UT22 arranged in the second row and the second column. FIGS. 4A to 4C show a separator SPR, light emitting parts EP1, EP2, and EP3 disposed in areas divided by the separator SPR, connection wirings CN1, CN2, and CN3, an anode (or a first electrode) EL1, and cathodes (or second electrodes) EL2_1, EL2_2, and EL2_3 among components of the display panel DP (refer to FIG. 1).

Each of the light emitting parts EP1, EP2, and EP3 may correspond to the light emitting opening OP-E (refer to FIG. 5A) described later. For example, each of the light emitting parts EP1, EP2, and EP3 may be an area from which the light is emitted by the light emitting device LD (refer to FIG. 2A or FIG. 2B) and may correspond to a unit providing the image displayed through the display panel DP.

The light emitting parts EP1, EP2, and EP3 may include a first light emitting part EP1, a second light emitting part EP2, and a third light emitting part EP3. The first light emitting part EP1, the second light emitting part EP2, and the third light emitting part EP3 may emit lights having different colors from each other. As an example, the first light emitting part EP1 may emit a red light, the second light emitting part EP2 may emit a green light, and the third light emitting part EP3 may emit a blue light, however, a combination of colors of lights emitted by the first, second, and third light emitting parts EP1, EP2, and EP3 should not be limited thereto or thereby.

Among the light emitting parts EP1, EP2, and EP3, the third light emitting part EP3 may include two sub-light emitting parts EP31 and EP32 spaced apart from each other in a second direction DR2, however, this is an example. According to an embodiment, the third light emitting part EP3 may be provided in a single pattern having an integral shape like the other light emitting parts EP1 and EP2, or at least one of the other light emitting parts EP1 and EP2 may include sub-light emitting parts, and the disclosure should not be particularly limited.

In an embodiment, the light emitting parts arranged in the first row Rk may include light emitting parts in a structure in which the light emitting unit UT11 arranged in the first row and the first column and the light emitting unit UT12 arranged in the first row and the second column are repeatedly and alternately arranged with each other. The light emitting parts arranged in the second row Rk+1 may include light emitting parts in a structure in which the light emitting unit UT21 arranged in the second row and the first column and the light emitting unit UT22 arranged in the second row and the second column are repeatedly and alternately arranged with each other. The shape of the third light emitting part EP3 constituting the light emitting unit UT11 may be axisymmetrical with that of the third emitting part EP3 constituting the light emitting unit UT21 with respect to the axis parallel to the first direction DR1. The shape of the third light emitting part EP3 constituting the light emitting unit UT12 may be axisymmetrical with that of the third emitting part EP3 constituting the light emitting unit UT22 with respect to the axis parallel to the first direction DR1.

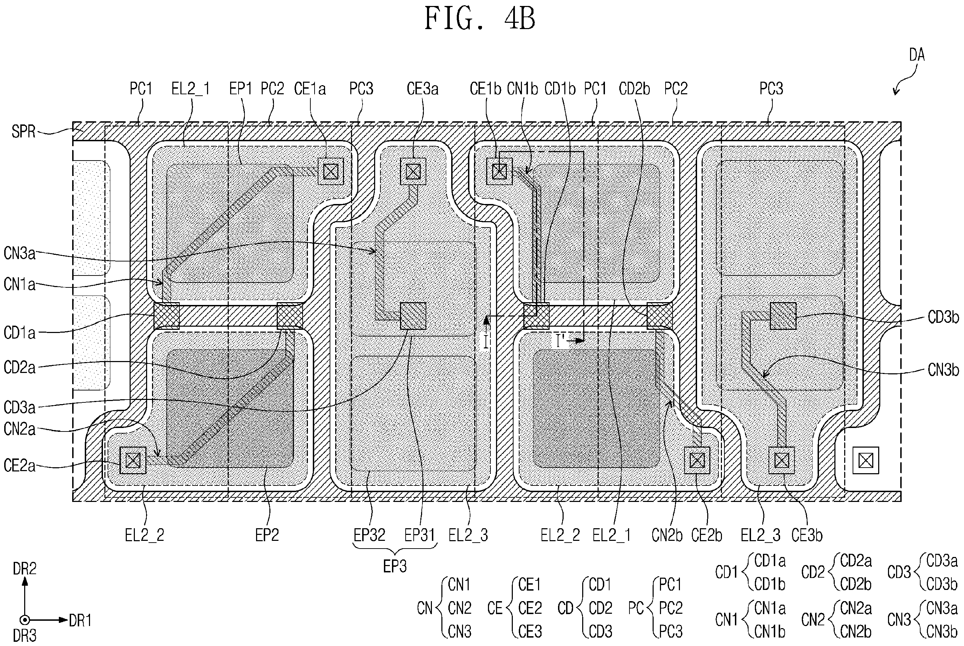

Hereinafter, the light emitting unit UT11 arranged in the first row and the first column will be described in detail. For the convenience of explanation, FIG. 4B shows the cathodes EL2_1, EL2_2, and EL2_3, the pixel drivers PC1, PC2, and PC3, and the connection wirings CN1, CN2, and CN3. The cathodes EL2_1, EL2_2, and EL2_3 may be separated from each other by the separator SPR. In an embodiment, one light emitting unit, for example, the light emitting unit UT11 arranged in the first row and the first column, may include three light emitting parts EP1, EP2, and EP3 and a portion of the separator SPR separating the three light emitting parts EP1, EP2, and EP3 from each other. Accordingly, one light emitting unit may include three cathodes EL2_1, EL2_2, and EL2_3 (hereinafter, referred to as first, second, and third cathodes), three pixel drivers PC1, PC2, and PC3 (hereinafter, referred to as first, second, and third pixel drivers), and three connection wirings CN1, CN2, and CN3 (hereinafter, referred to as first, second, and third connection wirings), however, this is an example. According to an embodiment, the number and arrangement of the light emitting units may be designed in various ways and should not be particularly limited.

The first, second, and third pixel drivers PC1, PC2, and PC3 may be respectively connected to the light emitting devices LD (refer to FIG. 2A or 2B) forming the first, second, and third light emitting parts EP1, EP2, and EP3. In the disclosure, the expression that a component A is connected to a component B may mean not only a case where the component A is directly and physically connected to the component B, but also a case where the component A is electrically connected to the component B.

The first, second, and third pixel drivers PC1, PC2, and PC3 may be sequentially arranged in the first direction DR1. The arrangement positions of the first, second, and third pixel drivers PC1, PC2, and PC3 may be designed independently from positions and shapes of the first, second, and third light emitting parts EP1, EP2, and EP3.

As an example, the first, second, and third pixel drivers PC1, PC2, and PC3 may be placed at positions different from the areas divided by the separator SPR, for example, positions at which the first, second, and third cathodes EL2_1, EL2_2, and EL2_3 are placed, or may be designed to have shapes and sizes different from the shapes and sizes of the first, second, and third cathodes EL2_1, EL2_2, and EL2_3. According to an embodiment, the first, second, and third pixel drivers PC1, PC2, and PC3 may be placed to respectively overlap the positions at which the first, second, and third light emitting parts EP1, EP2, and EP3 are placed and may be designed to have shapes and sizes similar to those of the areas divided by the separator SPR, for example, shapes and sizes of the first, second, and third cathodes EL2_1, EL2_2, and EL2_3.

In an embodiment, each of the first, second, and third pixel drivers PC1, PC2, and PC3 may have a rectangular shape, the first, second, and third light emitting parts EP1, EP2, and EP3 may be arranged in different arrangements, and the first, second, and third cathodes EL2_1, EL2_2, and EL2_3 may be placed at positions overlapping the first, second, and third light emitting parts EP1, EP2, and EP3 and may have an atypical shape.

Accordingly, as shown in FIG. 4B, the first pixel driver PC1 may be placed at a position overlapping the first light emitting part EP1, the second light emitting part EP2, and a portion of another light emitting unit adjacent thereto. The second pixel driver PC2 may be placed at a position overlapping the first light emitting part EP1, the second light emitting part EP2, and the third light emitting part EP3. The third pixel driver PC3 may be placed at a position overlapping the third light emitting part EP3, however, these are examples. According to an embodiment, the positions of the first, second, and third pixel drivers PC1, PC2, and PC3 may be designed to have various shapes and arrangements independently of the light emitting parts EP1, EP2, and EP3 and should not be particularly limited.

The connection wiring CN may be provided in plural, and the connection wirings CN may be arranged spaced apart from each other. Each of the connection wirings CN may connect the pixel driver PC and the light emitting device LD (refer to FIG. 2A or 2B). In detail, each of the connection wirings CN may correspond to the node (refer to N4 of FIG. 2A or N2 of FIG. 2B) at which the light emitting device LD (refer to FIG. 2A or 2B) is connected to the pixel driver PC.

The connection wiring CN may include a first connection part CE (hereinafter, referred to as an emission connection part) and a second connection part CD (hereinafter, referred to as a driver connection part). The emission connection part CE may be provided at one side or a side of the connection wiring CN, and the driver connection part CD may be provided at the other side of the connection wiring CN.

The driver connection part CD may be a portion of the connection wiring CN, which is connected to the pixel driver PC. In an embodiment, the driver connection part CD may be connected to one electrode of a transistor forming the pixel driver PC. In detail, the driver connection part CD may be connected to a drain of the sixth transistor T6 shown in FIG. 2A or the drain of the first transistor T1 shown in FIG. 2B. Accordingly, a position of the driver connection part CD may correspond to a position of a transistor (refer to TR of FIG. 5A) of the pixel driver PC, which is physically connected to the connection wiring CN.

The emission connection part CE may be a portion of the connection wiring CN, which is connected to the light emitting device LD (refer to FIG. 2A or 2B). In an embodiment, the emission connection part CE may be connected to the cathodes EL2_1, EL2_2, and EL2_3 of the light emitting device LD (refer to FIG. 2A or 2B).

In an embodiment, the connection wirings CN may include first connection wirings CN1, second connection wirings CN2, and third connection wirings CN3. The emission connection part CE may be provided for each connection wire CN, and the emission connection parts CE may include first emission connection parts CE1, second emission connection parts CE2, and third emission connection parts CE3. The driver connection part CD may be provided for each connection wire CN, and the driver connection parts CD may include first driver connection parts CD1, second driver connection parts CD2, and third driver connection parts CD3. The light emitting unit may include first, second, and third connection wirings CN1, CN2, and CN3. The first connection wiring CN1 may connect the light emitting device LD (refer to FIG. 2A or 2B), which forms the first light emitting part EP1, to the first pixel driver PC1, the second connection wiring CN2 may connect the light emitting device LD (refer to FIG. 2A or 2B), which forms the second light emitting part EP2, to the second pixel driver PC2, and the third connection wiring CN3 may connect the light emitting device LD (refer to FIG. 2A or 2B), which forms the third light emitting part EP3, to the third pixel driver PC3.

In detail, the first, second, and third connection wirings CN1, CN2, and CN3 may connect the first, second, and third cathodes EL2_1, EL2_2, and EL2_3 to the first, second, and third pixel drivers PC1, PC2, and PC3, respectively. The first connection wiring CN1 may include a first driver connection part CD1 connected to the first pixel driver PC1 and a first emission connection part CE1 connected to the first cathode EL2_1. The second connection wiring CN2 may include a second driver connection part CD2 connected to the second pixel driver PC2 and a second emission connection part CE2 connected to the second cathode EL2_2. The third connection wiring CN3 may include a third driver connection part CD3 connected to the third pixel driver PC3 and a third emission connection part CE3 connected to the third cathode EL2_3.

The first, second, and third driver connection parts CD1, CD2, and CD3 may be arranged in the first direction DR1. As described above, positions of the first, second, and third driver connection parts CD1, CD2, and CD3 may respectively correspond to positions of connection transistors forming the first, second, and third pixel drivers PC1, PC2, and PC3. In one pixel, the connection transistor may include the connection node at which the pixel driver PC is connected to the light emitting device LD (refer to FIG. 2A or 2B) as its electrode. As an example, the connection transistor may correspond to the sixth transistor T6 of FIG. 2A or the first transistor T1 of FIG. 2B. According to the disclosure, as the pixel driver is designed identically for all pixels regardless of the shape or size of the light emitting part and emission colors, a manufacturing process of the display panel DP (refer to FIG 3A) may be simplified, and a manufacturing cost of the display device DD may be reduced.

In an embodiment, the first, second, and third emission connection parts CE1, CE2, and CE3 may be defined at positions that do not overlap the light emitting parts EP1, EP2, and EP3 when viewed in the plan view. Each of the emission connection parts CE1, CE2, and CE3 may be provided at the position that does not overlap the light emitting opening OP-E (refer to FIG. 5A) since the emission connection part CE of the connection wiring CN is connected to the light emitting device LD (refer to FIG. 2A or 2B) and a tip part TIP (refer to FIG. 5A) is defined in the emission connection part CE of the connection wiring CN. For example, the emission connection parts CE1, CE2, and CE3 may be placed at the positions spaced apart from the light emitting parts EP1, EP2, and EP3, and the cathodes EL2_1, EL2_2, and EL2_3 may include some or a number of areas protruded from the light emitting parts EP1, EP2, and EP3 when viewed in the plan view to be connected to the connection wirings CN1, CN2, and CN3 at positions where the emission connection parts CE1, CE2, and CE3 are placed.

As an example, the first cathode EL2_1 may include a protruding portion protruded from the first light emitting part EP1 at the position that does not overlap the first light emitting part EP1 to be connected to the first connection wiring CN1 at the position where the first emission connection part CE1 is placed, and the first emission connection part CE1 may be provided in the protruding portion. Accordingly, the first cathode EL2_1 may be connected to the first connection wiring CN1 without reducing a light emitting area of the first light emitting part EP1.

In the first pixel driver PC1, the first driver connection part CD1 that is the position connected to the connection transistor TR (refer to FIG. 5A), may be defined at a position that does not overlap the first light emitting part EP1 when viewed in the plan view. According to an embodiment, as the first connection wiring CN1 is disposed in the first light emitting part EP1, the first cathode EL2_1 may be readily connected to the first pixel driver PC1 spaced apart from the first cathode EL2_1.

In the third pixel driver PC3, the third driver connection part CD3 that is the position connected to the connection transistor TR (refer to FIG. 5A) may be defined at a position that does not overlap the third emission connection part CE3 when viewed in the plan view and may be placed at a position overlapping the third light emitting part EP3. According to an embodiment, as the third cathode EL2_3 is connected to the third pixel driver PC3 via the third connection wiring CN3, the third pixel driver PC3 may be readily connected to the third cathode EL2_3 even though the third driver connection part CD3 overlaps the third light emitting part EP3 when viewed in the plan view. Accordingly, restrictions on the design of the third pixel driver PC3 due to the position or shape of the third light emitting part EP3 may be reduced, and the degree of freedom in circuit design may be improved.

A third emission connection part CE3a disposed in the light emitting unit UT11 arranged in the first row and the first column may be disposed spaced apart from the corresponding third light emitting part EP3 in the second direction DR2, and a third emission connection part CE3b disposed in the light emitting unit UT12 arranged in the first row and the second column may be disposed spaced apart from a corresponding third light emitting part EP3 in a direction opposite to the second direction DR2.

As shown in FIG. 4B, the first to third connection wirings CN1a, CN2a, and CN3a disposed in the light emitting unit UT11 arranged in the first row and the first column may include the first to third emission connection parts CE1a, CE2a, and CE3a and the first to third driver connection parts CD1a, CD2a, and CD3a, respectively. The first to third connection wirings CN1b, CN2b, and CN3b disposed in the light emitting unit UT12 arranged in the first row and the second column may also include the first to third emission connection parts CE1b, CE2b, and CE3b and the first to third driver connection parts CD1b, CD2b, and CD3b, respectively. A first emission connection part CE1a disposed in the light emitting unit UT11 arranged in the first row and the first column and a first emission connection part CE1b disposed in the light emitting unit UT12 arranged in the first row and the second column may be disposed spaced apart from each other in the first direction DR1 with the third emission connection part CE3a, which is disposed in the light emitting unit UT11 arranged in the first row and the first column, interposed therebetween. A second emission connection part CE2b disposed in the light emitting unit UT12 arranged in the first row and the second column and a second emission connection part disposed in the light emitting unit adjacent thereto, for example, the light emitting unit arranged in the first row and the third column, which has the same shape and arrangement as those of the light emitting unit UT11 arranged in the first row and the first column may be disposed spaced apart from each other in the first direction DR1 with the third emission connection part CE3b, which is disposed in the light emitting unit UT12 arranged in the first row and the second column, interposed therebetween.

The shape of the first and second light emitting parts EP1 and EP2 constituting the light emitting unit UT11 may be axisymmetric with that of the first and second light emitting parts constituting the light emitting unit UT12 with respect to the axis parallel to the second direction DR2. The shape of the third light emitting part EP3 constituting the light emitting unit UT11 may be axisymmetrical with that of the third emitting part EP3 constituting the light emitting unit UT12 with respect to the axis parallel to the first direction DR1 (or, symmetrical vertically based on the second direction DR2). Due to the relationship of the light emitting units UT11 and UT12 arranged in the first row, the light emitting units UT21 and UT22 arranged in the second row may include the light emitting parts obtained by shifting the light emitting units UT11 and UT12 arranged in the first row to the first direction DR1. For example, the light emitting unit UT21 arranged in the second row and the first column may include the light emitting parts having the same shape as that of the light emitting parts included in the light emitting unit UT12 arranged in the first row and the second column, and the light emitting unit UT22 arranged in the second row and the second column may include the light emitting parts having the same shape as that of the light emitting parts included in the light emitting unit UT11 arranged in the first row and the first column.

Accordingly, connection wirings CN-c arranged in the light emitting unit UT21 arranged in the second row and the first column may have the same shape and arrangement as those of connection wirings CN1b, CN2b, and CN3b arranged in the light emitting unit UT12 arranged in the first row and the second column. Similarly, connection wirings CN-d connected to the light emitting unit UT22 arranged in the second row and the second column may have the same shape and arrangement as those of the connection wirings CN1a, CN2a, and CN3a connected to the light emitting unit UT11 arranged in the first row and the first column.

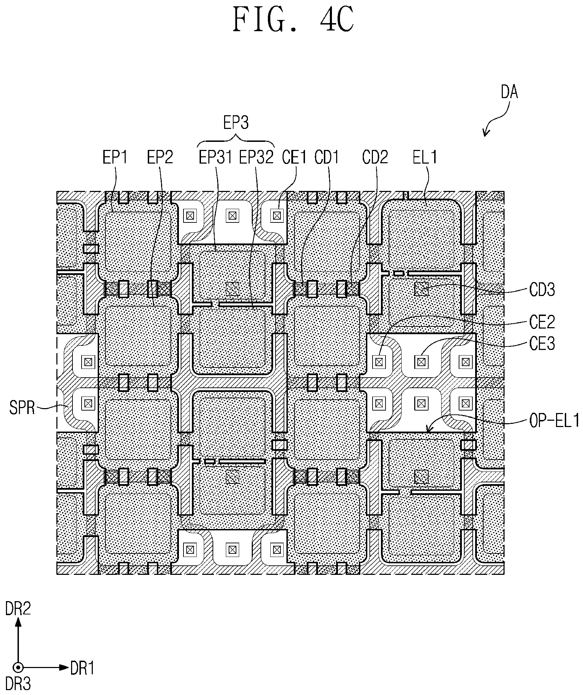

Referring to FIG. 4C, the first electrode EL1 (hereinafter, referred to as the anode) may be commonly disposed in the light emitting parts EP1, EP2, and EP3. For example, the anode EL1 may have an integral shape and may be disposed to overlap the light emitting parts EP1, EP2, and EP3 or the separator SPR. As described above, the first driving voltage VDD (refer to FIG. 2A) may be applied to the anode EL1, and a common voltage may be applied to all the light emitting parts EP1, EP2, and EP3. The anode EL1 may be connected to the first power line VDL (refer to FIG. 2A) providing the first driving voltage VDD (refer to FIG. 1) in the peripheral area NDA or may be connected to the first power line VDL (refer to FIG. 2A) in the display area DA, and it should not be limited thereto or thereby.

Openings OP-EL1 may be defined through the anode EL1, and the openings OP-EL1 may penetrate through the anode EL1. The openings OP-EL1 may be defined not to overlap the light emitting parts EP1, EP2, and EP3 and may be defined to overlap the separator SPR. The openings OP-EL1 may facilitate a discharge of a gas generated from an organic layer disposed under or below the anode EL1, for example, a sixth insulating layer 60 (refer to FIG. 5A). Accordingly, the gas from the organic layer may be sufficiently discharged in a manufacturing process of the display panel DP (refer to FIG. 1), and, deterioration of the light emitting device LD (refer to FIG. 2A or 2B), which is caused by the gas generated from the organic layer, may be improved.

According to the disclosure, different from the light emitting devices in which the cathode overlaps a corresponding connection transistor of the pixel driver when viewed in the plan view, the light emitting devices including the cathode having the shape that does not overlap the connection transistor of the pixel driver may be readily connected to the pixel driver since the display panel further may include the connection wiring. According to the disclosure, as the display panel further may include the connection wiring, the light emitting device may be stably connected to the pixel driver by changing only the shape of the cathode without changing the design of the light emitting parts. Accordingly, the influence of the arrangement or shape of the light emitting parts on the connection between the light emitting devices and the pixel driver may be reduced, a design freedom for the arrangement of the pixel driver may be improved, and deterioration in aperture ratio of the light emitting part may be prevented.

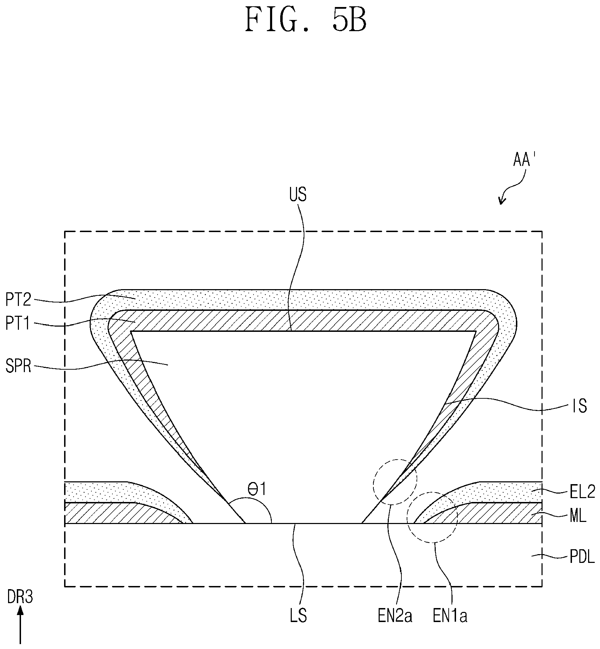

FIG. 5A is an enlarged schematic cross-sectional view of the display panel DP taken along line I-I' of FIG. 4B according to an embodiment. FIG. 5B is an enlarged schematic cross-sectional view of an area AA' of FIG. 5A according to embodiments.

Referring to FIG. 5A, the display panel DP may include a base layer BS, a driving device layer DDL, a connection wiring CN, a sixth insulating layer 60, a light emitting device layer LDL, an encapsulation layer ECL, and a sensing layer ISL. The driving device layer DDL may include insulating layers 10, 20, 30, 40, and 50 disposed on the base layer BS, and conductive patterns and semiconductor patterns, which are disposed between the insulating layers. The conductive patterns and the semiconductor patterns disposed between the insulating layers may form the pixel driver PC. For the convenience of explanation, FIG. 5A shows a cross-section of a portion of an area in which one light emitting part is disposed.

The base layer BS may provide a base surface on which the pixel driver PC is disposed. The base layer BS may be a rigid substrate or a flexible substrate that is bendable, foldable, or rollable. The base layer BS may be a glass substrate, a metal substrate, or a polymer substrate, however, it should not be limited thereto or thereby. According to an embodiment, the base layer BS may be an inorganic layer, an organic layer, or a composite material layer.

The base layer BS may have a multi-layer structure. For instance, the base layer BS may include a first polymer resin layer, a silicon oxide (SiOₓ) layer disposed on the first polymer resin layer, an amorphous silicon (a-Si) layer disposed on the silicon oxide layer, and a second polymer resin layer disposed on the amorphous silicon (a-Si) layer. The silicon oxide (SiOₓ) layer and the amorphous silicon (a-Si) layer may be referred to as a base barrier layer.

Each of the first and second polymer resin layers may include a polyimide-based resin. Each of the first and second polymer resin layers may include at least one of an acrylic-based resin, a methacrylic-based resin, a polyisoprene-based resin, a vinyl-based resin, an epoxy-based resin, a urethane-based resin, a cellulose-based resin, a siloxane-based resin, a polyamide-based resin, and a perylene-based resin. In the disclosure, the term "X-based resin", as used herein, refers to the resin that may include a functional group of X.

The display panel DP may include insulating layers, conductive layers, and semiconductor layers, which are disposed on the base layer BS and each of which formed through coating and deposition processes. An organic layer, an inorganic layer, a semiconductor layer, and a conductive layer may be selectively patterned through several photolithography processes, and thus, holes defined through the insulating layers or the semiconductor pattern, the conductive pattern, and the signal line may be formed.

The driving device layer DDL may include first, second, third, fourth, and fifth insulating layers 10, 20, 30, 40, and 50, which may be sequentially stacked on each other on the base layer BS, and the pixel driver PC. FIG. 5A shows one transistor TR and two capacitors C1 and C2 of the pixel driver PC. The transistor TR may correspond to a transistor connected to the light emitting device LD via the connection wiring CN, for example, the connection transistor connected to the node (the fourth node N4 of FIG. 2A or the second node N2 of FIG. 2B) corresponding to a cathode EL2 of the light emitting device LD. In detail, the transistor TR may correspond to the sixth transistor T6 of FIG. 2A or the first transistor T1 of FIG. 2B. Although not shown in figures, other transistors forming the pixel driver PC may have substantially the same structure as that of the transistor TR (hereinafter, referred to as the connection transistor) shown in FIG. 5A, however, this is an example. According to an embodiment, other transistors forming the pixel driver PC may have a structure different from the connection transistor TR and should not be particularly limited.

The first insulating layer 10 may be disposed on the base layer BS. The first insulating layer 10 may be an inorganic layer and/or an organic layer and may have a single-layer or multi-layer structure. The first insulating layer 10 may include at least one of aluminium oxide, titanium oxide, silicon oxide, silicon nitride, silicon oxynitride, zirconium oxide, and hafnium oxide. In an embodiment, the first insulating layer 10 may have a single-layer structure of a silicon oxide layer. Insulating layers described later may be an inorganic layer and/or an organic layer and may have a single-layer or multi-layer structure. The inorganic layer may include at least one of the above-mentioned materials, however, it should not be limited thereto or thereby.

The first insulating layer 10 may cover a bottom conductive layer BCL. For example, the display panel may further include the bottom conductive layer BCL disposed under or below the connection transistor TR and overlapping the connection transistor TR. The bottom conductive layer BCL may prevent an electric potential caused by a polarization phenomenon of the base layer BS from exerting influence on the connection transistor TR. The bottom conductive layer BCL may block a light incident into the connection transistor TR from a lower side of the bottom conductive layer BCL. At least one of an inorganic barrier layer and a buffer layer may be further disposed between the bottom conductive layer BCL and the base layer BS.

The bottom conductive layer BCL may include a reflective metal material. As an example, the bottom conductive layer BCL may include titanium (Ti), molybdenum (Mo), an alloy including molybdenum (Mo), aluminium (Al), an alloy including aluminium (Al), aluminium nitride (AlN), tungsten (W), tungsten nitride (WN), and copper (Cu).

In an embodiment, the bottom conductive layer BCL may be connected to a source (or the source area SR of the semiconductor pattern SP) of the connection transistor TR via a source electrode pattern W1. The bottom conductive layer BCL may be synchronized with the source of the connection transistor TR, however, this is an example. According to an embodiment, the bottom conductive layer BCL may be connected to and synchronized with a gate (or a gate electrode GE) of the connection transistor TR. According to an embodiment, the bottom conductive layer BCL may be connected to another electrode to independently receive a constant voltage or a pulse signal. According to an embodiment, the bottom conductive layer BCL may be provided in an isolated form isolated from other conductive patterns. The bottom conductive layer BCL may be provided in a variety of shapes and should not be particularly limited.

The connection transistor TR may be disposed on the first insulating layer 10. The connection transistor TR may include the semiconductor pattern SP and the gate electrode GE. The semiconductor pattern SP may be disposed on the first insulating layer 10. The semiconductor pattern SP may include an oxide semiconductor. As an example, the oxide semiconductor may include a transparent conductive oxide (TCO), such as indium tin oxide (ITO), indium zinc oxide (IZO), indium gallium zinc oxide (IGZO), zinc oxide (ZnO), indium oxide (In₂O₃), or the like, however, the material for the semiconductor pattern SP should not be limited thereto or thereby. As an example, the semiconductor pattern may include amorphous silicon, low temperature polycrystalline silicon, or polycrystalline silicon.

The second insulating layer 20 may commonly overlap the pixels and may cover the semiconductor pattern SP The second insulating layer 20 may be an inorganic layer and/or an organic layer and may have a single-layer or multi-layer structure. The second insulating layer 20 may include at least one of aluminium oxide, titanium oxide, silicon oxide, silicon nitride, silicon oxynitride, zirconium oxide, and hafnium oxide. In an embodiment, the second insulating layer 20 may have a single-layer structure of a silicon oxide layer.

The semiconductor pattern SP may include the source area SR, a drain area DR, and a channel area CR ( or an active area) distinguished from each other depending on a degree of conductivity. The channel area CR may overlap the gate electrode GE when viewed in the plan view. The source area SR and the drain area DR may be spaced apart from each other with the channel area CR interposed therebetween. When the semiconductor pattern SP is the oxide semiconductor, each of the source area SR and the drain area DR may be a reduced area. Accordingly, the source area SR and the drain area DR may have a relatively high content of reduced metal compared with the channel area CR. According to an embodiment, when the semiconductor pattern SP is the polycrystalline silicon, each of the source area SR and the drain area DR may be a highly doped area.

The source area SR and the drain area DR may have a relatively high conductivity compared with the channel area CR. The source area SR may correspond to a source electrode of the connection transistor TR, and the drain area DR may correspond to a drain electrode of the connection transistor TR. As shown in FIG. 5A, the source electrode pattern W1 and a drain electrode pattern W2 may be further provided among conductive patterns W1, W2, CPE1, CPE2, and CPE3, and the source electrode pattern W1 and the drain electrode pattern W2 may be connected to the source area SR and the drain area DR of the connection transistor TR, respectively. In detail, each of the source electrode pattern W1 and the drain electrode pattern W2, which are separated from each other, may be integral with one of the lines forming the pixel driver PC, however, it should not be limited thereto or thereby.

The gate electrode GE may be disposed on the second insulating layer 20. The gate electrode GE may correspond to the gate of the connection transistor TR. The gate electrode GE may be disposed on the semiconductor pattern SP, however, this is an example. According to an embodiment, the gate electrode GE may be disposed under or below the semiconductor pattern SP, and it should not be particularly limited.

The gate electrode GE may include titanium (Ti), silver (Ag), molybdenum (Mo), aluminium (Al), tungsten (W), copper (Cu), or an alloy thereof, or aluminum nitride (AlNₓ), or tungsten nitride (WNₓ), however, it should not be particularly limited.

Among the conductive patterns W1, W2, CPE1, CPE2, and CPE3, a first capacitor electrode CPE1 and a second capacitor electrode CPE2 may form the first capacitor C1. The first capacitor electrode CPE1 and the second capacitor electrode CPE2 may be spaced apart from each other with the first insulating layer 10 and the second insulating layer 20 interposed therebetween.

According to an embodiment, the first capacitor electrode CPE1 and the bottom conductive layer BCL may be integral with each other. The second capacitor electrode CPE2 may be integral with the gate electrode GE.

A third capacitor electrode CPE3 may be disposed on the third insulating layer 30. The third capacitor electrode CPE3 may be spaced apart from the second capacitor electrode CPE2 with the third insulating layer 30 interposed therebetween and may overlap the second capacitor electrode CPE2. The third capacitor electrode CPE3 and the second capacitor electrode CPE2 may form the second capacitor C2.

The fourth insulating layer 40 may be disposed on the third capacitor electrode CPE3.

The source electrode pattern W1 and the drain electrode pattern W2 may be disposed on the fourth insulating layer 40. The source electrode pattern W1 may be connected to the source area SR of the connection transistor TR via a first contact hole CNT1, and the source electrode pattern W1 and the source area SR of the semiconductor pattern SP may serve as the source of the connection transistor TR. The drain electrode pattern W2 may be connected to the drain area DR of the connection transistor TR via a second contact hole CNT2, and the drain electrode pattern W2 and the drain area DR of the semiconductor pattern SP may serve as the drain of the connection transistor TR.

The fifth insulating layer 50 may be disposed on the source electrode pattern W1 and the drain electrode pattern W2. The connection wiring CN may be disposed on the fifth insulating layer 50. The connection wiring CN may connect the connection transistor TR to the light emitting device LD. The connection wiring CN may be a connection node that connects the pixel driver PC to the light emitting device LD. For example, the connection wiring CN may correspond to the fourth node N4 shown in FIG. 2A or may correspond to the second node N2 shown in FIG. 2B, however, this is an example. The connection wiring CN may be defined as a connection node connected to various components of the pixel driver PC according to the design of the pixel driver PC as long as the connection wiring CN is connected to the light emitting device LD, and it should not be particularly limited.

The connection wiring CN may have a three-layer structure. In detail, the connection wiring CN may include a first layer L1, a second layer L2, and a third layer L3, which may be sequentially stacked in a third direction DR3.

Each of the first and third layers L1 and L3 may have a relatively thinner thickness than that of the second layer L2. The first and third layers L1 and L3 may include the same material or similar material as each other, and the second layer L2 may include a material different from that of the first and third layers L1 and L3. The second layer L2 may have an etch rate higher than an etch rate of each of the first and third layers L1 and L3. For example, the second layer L2 may include a material having an etch selectivity with respect to each of the first and third layers L1 and L3. As an example, each of the first and third layers L1 and L3 may include titanium (Ti), and the second layer L2 may include aluminium (Al). However, the materials for the first, second, and third layers L1, L2, and L3 should not be particularly limited.

A side surface of the third layer L3 may protrude outward from a side surface of the second layer L2. For example, the side surface of the second layer L2 may be disposed inside the side surface of the third layer L3 and may have an undercut shape or an overhang structure. The tip part TIP of the emission connection part CE may be defined by a portion of the third layer L3, which is protruded outward from the second layer L2.

The sixth insulating layer 60 may be disposed between the driving device layer DDL and the light emitting device layer LDL. The sixth insulating layer 60 may be disposed on the fifth insulating layer 50 and may cover the connection wiring CN. Each of the fifth insulating layer 50 and the sixth insulating layer 60 may be an organic layer. As an example, each of the fifth insulating layer 50 and the sixth insulating layer 60 may include a general-purpose polymer, such as benzocyclobutene (BCB), polyimide, hexamethyldisiloxane (HMDSO), polymethylmethacrylate (PMMA), or polystyrene (PS), a polymer derivative having a phenolic group, an acrylic-based polymer, an imide-based polymer, an aryl ether-based polymer, an amide-based polymer, a fluorine-based polymer, a p-xylene-based polymer, a vinyl alcohol-based polymer, or blends thereof.

The sixth insulating layer 60 may be provided with a first contact opening OP-C1 defined therethrough to expose at least a portion of the connection wiring CN. In detail, the side surface of the third layer L3 in which the tip part TIP is defined and the side surface of each of the first and second layers L1 and L2 adjacent to the side surface of the third layer L3 may be exposed without being covered by the sixth insulating layer 60.

The connection wiring CN may be connected to the connection transistor TR after penetrating through the fifth insulating layer 50 and may be connected to the light emitting device LD of the light emitting device layer LDL through the portion thereof exposed without being covered by the sixth insulating layer 60. For example, the connection wiring may connect the connection transistor TR to the light emitting device LD. This will be described in detail later.

The light emitting device layer LDL may be disposed on the sixth insulating layer 60. The light emitting device layer LDL may include a pixel definition layer PDL, the light emitting device LD, and the separator SPR. According to an embodiment, the sixth insulating layer 60 may be omitted from the display panel DP or may be provided in plural, and it should not be particularly limited.

The pixel definition layer PDL may be an organic layer. As an example, the pixel definition layer PDL may include a general-purpose polymer, such as benzocyclobutene (BCB), polyimide, hexamethyldisiloxane (HMDSO), polymethylmethacrylate (PMMA), or polystyrene (PS), a polymer derivative having a phenolic group, an acrylic-based polymer, an imide-based polymer, an aryl ether-based polymer, an amide-based polymer, a fluorine-based polymer, a p-xylene-based polymer, a vinyl alcohol-based polymer, or blends thereof.

The pixel definition layer PDL may have a light absorbing property. For example, the pixel definition layer PDL may have a black color. The pixel definition layer PDL may include a black coloring agent. The black coloring agent may include a black dye or a black pigment. The black coloring agent may include carbon black, a metal material, such as chromium, or an oxide thereof. The pixel definition layer PDL may correspond to a light blocking pattern having a light blocking property.

The pixel definition layer PDL may be provided with an opening OP-E (hereinafter, referred to as a light emitting opening) defined therethrough. The light emitting opening OP-E may be provided in plural, and the light emitting openings OP-E may respectively correspond to the light emitting devices LD. All components of the light emitting device LD may overlap each other in the light emitting opening OP-E, and the light emitting opening OP-E may correspond to an area where the light emitted from the light emitting device LD is substantially displayed. Accordingly, the shape of the light emitting part EP (refer to FIG. 3A) may substantially correspond to the shape of the light emitting opening OP-E when viewed in the plan view.

In an embodiment, a second contact opening OP-C2 corresponding to the first contact opening OP-C1 may be defined through the pixel definition layer PDL. The second contact opening OP-C2 may be spaced apart from the light emitting opening OP-E. The second contact opening OP-C2 may have a size equal to or greater than a size of the first contact opening OP-C1 when viewed in the plan view. The side surface of the third layer L3 in which the tip part TIP is defined and the side surface of each of the first and second layers L1 and L2 may be exposed without being covered by the pixel definition layer PDL.

The light emitting device LD may include the first electrode EL1, an intermediate layer ML, and the second electrode EL2. The first electrode EL1 may be a semi-transmissive electrode, a transmissive electrode, or a reflective electrode. According to an embodiment, the first electrode EL1 may include a reflective layer formed of silver (Ag), magnesium (Mg), aluminium (Al), platinum (Pt), palladium (Pd), gold (Au), nickel (Ni), neodymium (Nd), iridium (Ir), chromium (Cr), or compounds thereof and a transparent or semi-transparent electrode layer formed on the reflective layer. The transparent or semi-transparent electrode layer may include at least one selected from the group consisting of indium tin oxide (ITO), indium zinc oxide (IZO), indium gallium zinc oxide (IGZO), zinc oxide (ZnO), indium oxide (In₂O₃), and aluminium-doped zinc oxide (AZO). For instance, the first electrode EL1 may have a stack structure of ITO/Ag/ITO.

In an embodiment, the first electrode EL1 may be the anode of the light emitting device LD and may correspond to the anode EL1 described with reference to FIG. 4C. For example, the first electrode EL1 may be connected to the first power line VDL (refer to FIGS. 2A and 2B) and may receive the first driving voltage VDD (refer to FIGS. 2A and 2B). The first electrode EL1 may be connected to the first power line VDL (refer to FIGS. 2A and 2B) in the display area DA (refer to FIG. 3A) or may be connected to the first power line VDL (refer to FIGS. 2A and 2B) in the peripheral area NDA (refer to FIG. 3A). In the case where the first electrode EL1 is connected to the first power line VDL (refer to FIGS. 2A and 2B) in the peripheral area NDA (refer to FIG. 3A), the first power line VDL (refer to FIGS. 2A and 2B) may be disposed in the peripheral area NDA, and the first electrode EL1 may extend to the peripheral area NDA (refer to FIG. 3A).

In an embodiment, the first electrode EL1 overlaps the light emitting opening OP-E and does not overlap the separator SPR, however, it should not be limited thereto or thereby. As described above, the first electrodes of each pixel may have an integral shape and may have a mesh or lattice shape in which openings are defined in some or a number of areas. For example, the first electrode EL1 may have a variety of shapes as long as the light emitting devices receive the same first driving voltage VDD through their first electrodes EL1, however, it should not be limited thereto or thereby.

The intermediate layer ML may be disposed between the first electrode EL1 and the second electrode EL2. The intermediate layer ML may include a light emitting layer EML and a functional layer FNL, however, this is an example. The light emitting device LD may include the intermediate layer ML with various structures and should not be particularly limited. As an example, the functional layer FNL may include layers or may include two or more layers spaced apart from each other with the light emitting layer EML interposed therebetween. According to an embodiment, the functional layer FNL may be omitted.

The light emitting layer EML may absorb an energy corresponding to a difference in electric potential between the first electrode EL1 and the second electrode EL2 and may emit the light. The light emitting layer EML may include an organic light emitting material, however, it should not be limited thereto or thereby. According to an embodiment, the light emitting layer EML may include an inorganic light emitting material or may include a layer obtained by mixing the organic light emitting material with the inorganic light emitting material.

The light emitting layer EML may be disposed to overlap the light emitting opening OP-E. In an embodiment, the light emitting layer EML may be formed separately in each of the pixels. In the case where the light emitting layer EML is formed separately in each of the light emitting parts EP (refer to FIG. 3A), the light emitting layer EML may emit the light having at least one of blue, red, and green colors, however, it should not be limited thereto or thereby. According to an embodiment, the light emitting layer EML may have an integral shape to be commonly disposed in the light emitting parts EP (refer to FIG. 3A) adjacent to each other. The light emitting layer EML may provide a blue light or a white light. The light emitting layer EML may have substantially the same shape as that of the functional layer FNL and may be integral with the functional layer FNL without a layer boundary with respect to the functional layer FNL, so that the intermediate layer ML including the light emitting layer EML integral with the functional layer FNL may be provided.

The functional layer FNL may be disposed between the first electrode EL1 and the second electrode EL2. In detail, the functional layer FNL may be disposed between the first electrode EL1 and the light emitting layer EML or may be disposed between the second electrode EL2 and the light emitting layer EML. According to an embodiment, the functional layer FNL may be disposed between the first electrode EL1 and the light emitting layer EML and between the second electrode EL2 and the light emitting layer EML. In an embodiment, the light emitting layer EML may be inserted into the functional layer FNL, however, this is an example. According to an embodiment, the functional layer FNL may include a layer disposed between the light emitting layer EML and the first electrode EL1 and/or a layer disposed between the light emitting layer EML and the second electrode EL2, and each of the layers may be provided in plural. However, they should not be limited thereto or thereby.

The functional layer FNL may control a movement of electric charges. The functional layer FNL may include a hole injection/transport material and/or an electron injection/transport material. The functional layer FNL may include at least one of an electron block layer, a hole transport layer, a hole injection layer, a hole block layer, an electron transport layer, an electron injection layer, and an electric charge generating layer.

The second electrode EL2 may be disposed on the intermediate layer ML. As described above, the second electrode EL2 may be connected to the pixel driver PC via the fourth node N4 of FIG. 2A or the second node N2 of FIG. 2B. In an embodiment, the second electrode EL2 may be electrically connected to the connection transistor TR via the connection wiring CN.

The connection wiring CN may include the driver connection part CD and the emission connection part CE. For the convenience of explanation, FIG. 5A shows the driver connection part CD and the emission connection part CE, a portion of the connection wiring CN connecting the driver connection part CD and the emission connection part CE is omitted.

The driver connection part CD of the connection wiring CN may be connected to the pixel driver PC and may be substantially connected to the connection transistor TR. In an embodiment, the driver connection part CD may be connected to the drain area DR of the semiconductor pattern SP via the drain electrode pattern W2 of the connection transistor TR after penetrating through the fifth insulating layer 50.

The emission connection part CE may be a portion of the connection wiring CN connected to the light emitting device LD. One side or a side of the connection wiring CN may be exposed via the first contact opening OP-C1 of the sixth insulating layer 60 and the second contact opening OP-C2 of the pixel definition layer PDL. The emission connection part CE may be defined in an area exposed without being covered by the sixth insulating layer 60 and the pixel definition layer PDL, and the second electrode EL2 may be directly in contact with the emission connection part CE. In detail, the second electrode EL2 may be in contact with the side surface of the second layer L2 exposed without being covered by the sixth insulating layer 60.

The intermediate layer ML may be disposed on the pixel definition layer PDL. The intermediate layer ML may also be disposed on a portion of the sixth insulating layer 60, which is exposed via the second contact opening OP-C2 defined through the pixel definition layer PDL. The intermediate layer ML may also be disposed on a portion of the connection wiring CN, which is exposed via the first contact opening OP-C1 defined through the sixth insulating layer 60.

The intermediate layer ML may include one end disposed along an upper surface of the fifth insulating layer 50 and the other end disposed along an upper surface of the tip part TIP of the connection wiring CN. For example, when viewed in the cross-section, the intermediate layer ML may be partially disconnected in an area where the emission connection part CE is defined around the tip part TIP. However, when viewed in the plan view, the intermediate layer ML may have a shape as a whole within an area defined as a closed-line by the separator SPR.

The second electrode EL2 may include one end disposed along the upper surface of the fifth insulating layer 50 and the other end disposed along the upper surface of the tip part TIP of the connection wiring CN. For example, when viewed in the cross-section, the second electrode EL2 may be partially disconnected in the area where the emission connection part CE is defined around the tip part TIP. However, when viewed in the plan view, the second electrode EL2 may have a shape as a whole within an area defined as a closed-line by the separator SPR.

The one end of the second electrode EL2 may be disposed along the side surface of the second layer L2 and may be in contact with the side surface of the second layer L2. In detail, since there is a difference in deposition angle between the second electrode EL2 and the intermediate layer ML, the second electrode EL2 may be formed to be in contact with the side surface of the second layer L2 exposed without being covered by the intermediate layer ML due to the tip part TIP. For example, the second electrode EL2 may be connected to the connection wiring CN without performing a separate patterning process on the intermediate layer ML, and thus, the light emitting device LD may be electrically connected to the pixel driver PC via the connection wiring CN.

In an embodiment, the separator SPR may be disposed on the pixel definition layer PDL. The separator SPR may have a multi-layer structure including at least one of an organic material, a metal material, and a transparent electrode. According to an embodiment, the second electrode EL2 and the intermediate layer ML may be commonly formed in the pixels using an open mask. The second electrode EL2 may be divided by the separator SPR, and the second electrode EL2 may be divided into plural portions respectively corresponding to the light emitting parts EP (refer to FIG. 3A). For example, the second electrode EL2 may be electrically independent from another second electrode EL2 of the pixels adjacent thereto.

A first separation pattern layer PT1 and a second separation pattern layer PT2 may be disposed on the separator SPR, and this structure will be described in detail later.

FIG. 5B is an enlarged schematic cross-sectional view of an area AA' of FIG. 5A. FIG. 5B is an enlarged view of the separator SPR according to an embodiment of the disclosure.

Referring to FIG. 5B, the separator SPR may be disposed on the pixel definition layer PDL. The separator SPR may have a reverse-tapered shape. For example, an interior angle θ1 between the upper surface of the pixel definition layer PDL (or a lower surface LS of the separator SPR) and an inner side surface IS of the separator SPR may be an obtuse angle, however, this is an example. According to an embodiment, the interior angle θ1 between the inner side surface IS and the lower surface LS of the separator SPR may be set in various ways as long as the separator SPR electrically disconnects the second electrode EL2 in each pixel from the second electrode EL2 in another pixel adjacent to the each pixel.

The separator SPR may include an organic material and may have an insulating property. Deposition layers, for instance, the intermediate layer ML and the second electrode EL2, may be disconnected by the separator SPR. The intermediate layer ML and the second electrode EL2 included in one light emitting device may be separated from the intermediate layer ML and the second electrode EL2, which are included in the light emitting device adjacent thereto by the separator SPR.

A first end portion EN1a and a second end portion EN2a may be formed in the deposition layer by the separator SPR. The first end portion EN1a may be separated from the separator SPR and may be placed on the pixel definition layer PDL. The second end portion EN2a may be separated from the first end portion EN1a and may cover the inner side surface IS of the separator SPR. FIG. 5B shows the structure in which the first end portion EN1a is spaced apart from the inner side surface IS of the separator SPR by a selectable distance, however, the disclosure should not be limited thereto or thereby. According to an embodiment, the first end portion EN1a may be in contact with the inner side surface IS of the separator SPR.

The formation of the first and second end portions EN1a and EN2a may mean an electrical disconnection of the deposition layer. However, the deposition layer may be considered as being divided by the separator SPR in a case where the first end portions EN1a and the second end portion EN2a are not formed in the deposition layer, the deposition layer is thinly formed along the inner side surface IS of the separator SPR, and no electrical connection is made between a portion formed on the separator SPR and a portion formed on the pixel defining layer PDL and adjacent to the portion formed on the separator SPR.

The first separation pattern layer PT1 and the second separation pattern layer PT2 may be disposed on the separator SPR.

The first separation pattern layer PT1 may be disposed on the upper surface US and the inner side surface IS of the separator SPR. The first separation pattern layer PT1 may include the same material or similar material as that of the intermediate layer ML. The first separation pattern layer PT1 may be a residue separated from the intermediate layer ML by the separator SPR when the intermediate layer ML is commonly formed.

The second separation pattern layer PT2 may include the same material or similar material as that of the second electrode EL2. The second separation pattern layer PT2 may be a residue separated from the second electrode EL2 by the separator SPR when the second electrode EL2 is commonly formed.

In an embodiment, each of the first separation pattern layer PT1 and the second separation pattern layer PT2 may have substantially the same shape as a shape of the separator SPR when viewed in the plan view. Each of the first separation pattern layer PT1 and the second separation pattern layer PT2 may have an integral shape when viewed in the plan view. By way of example, according to an embodiment, the second separation pattern layer PT2 may extend from the display area DA to an area in which a power line is disposed in the peripheral area NDA and may have a shape entirely electrically connected to the power line. Accordingly, the second separation pattern layer PT2 may receive the constant voltage from the power line, and the second separation pattern layer PT2 may be referred to as a separation conductive layer. This will be described in detail later.

According to the disclosure, although the separate patterning process using the mask is not performed when the second electrode EL2 and the intermediate layer ML are formed, the second electrode EL2 or the intermediate layer ML may not be formed on the inner side surface IS of the separator SPR or may be formed to have a thin thickness, and thus, the second electrode EL2 or the intermediate layer ML may be readily separated for each pixel, however, this is an example. According to an embodiment, the shape of the separator SPR may be changed in various ways as long as each of the second electrode EL2 and the intermediate layer ML is disconnected.

Referring to FIG. 5A again, the encapsulation layer ECL may be disposed on the pixel definition layer PDL and may cover the separator SPR. The encapsulation layer ECL may include a first inorganic layer IL1, an organic layer OL, and a second inorganic layer IL2, which may be sequentially stacked each other, however, it should not be limited thereto or thereby. According to an embodiment, the encapsulation layer ECL may further include inorganic layers and organic layers.

The first and second inorganic layers IL1 and IL2 may protect the light emitting device layer LDL from moisture and oxygen, and the organic layer OL may protect the light emitting device layer LDL from a foreign substance such as dust particles. The first and second inorganic layers IL1 and IL2 may include a silicon nitride layer, a silicon oxynitride layer, a silicon oxide layer, a titanium oxide layer, or an aluminium oxide layer. The organic layer OL may include an acrylic-based organic layer, however, it should not be particularly limited.

The sensing layer ISL may sense external inputs. The sensing layer ISL may be formed on the encapsulation layer ECL through successive processes. The sensing layer ISL may be disposed directly on the encapsulation layer ECL. In the disclosure, the expression "the sensing layer ISL is disposed directly on the encapsulation layer ECL" means that no intervening elements are present between the sensing layer ISL and the encapsulation layer ECL. For example, a separate adhesive member may not be disposed between the sensing layer ISL and the encapsulation layer ECL, however, this is an example. According to an embodiment, the sensing layer ISL may be provided in the display device DD (refer to FIG. 1) after being separately formed and may be coupled or connected to the encapsulation layer ECL by an adhesive member, but it should not be limited thereto or thereby.

The sensing layer ISL may include conductive layers MTL1 and MTL2 and sensing insulating layers 71, 72, and 73. The sensing insulating layers 71, 72, and 73 may include first, second, and third sensing insulating layers 71, 72, and 73. However, this is an example, and the number of sensing insulating layers should not be particularly limited.

The first sensing insulating layer 71 may be an inorganic layer including at least one of silicon nitride, silicon oxynitride, and silicon oxide. According to an embodiment, the first sensing insulating layer 71 may be an organic layer including an epoxy-based resin, an acrylic-based resin, or an imide-based resin. The first sensing insulating layer 71 may have a single-layer structure or a multi-layer structure of layers stacked each other in the third direction DR3.

The conductive layers MTL1 and MTL2 may include a first conductive layer MTL1 and a second conductive layer MTL2. The first conductive layer MTL1 may be disposed between the first sensing insulating layer 71 and the second sensing insulating layer 72, and the second conductive layer MTL2 may be disposed between the second sensing insulating layer 72 and the third sensing insulating layer 73. A portion of the second conductive layer MTL2 may be connected to the first conductive layer MTL1 via a contact hole CNT-1 formed through the second sensing insulating layer 72. Each of the first and second conductive layers MTL1 and MTL2 may have a single-layer structure or a multi-layer structure of layers stacked each other in the third direction DR3.

The conductive layer having the single-layer structure may include a metal layer or a transparent conductive layer. The metal layer may include molybdenum, silver, titanium, copper, aluminium, or alloys thereof. The transparent conductive layer may include a transparent conductive oxide, such as indium tin oxide (ITO), indium zinc oxide (IZO), zinc oxide (ZnO), indium zinc tin oxide (IZTO), or the like within the scope of the disclosure. The transparent conductive layer may include conductive polymer such as PEDOT, metal nanowire, graphene, or the like within the scope of the disclosure.

The conductive layer having the multi-layer structure may include metal layers. The metal layers may have a three-layer structure of titanium/aluminium/titanium. The conductive layer having the multi-layer structure may include at least one metal layer and at least one transparent conductive layer.

The first conductive layer MTL1 and the second conductive layer MTL2 may form a sensor to sense the external inputs in the sensing layer ISL. The sensor may be driven in a capacitive method, for example, a mutual capacitive method or a self-capacitive method, however, this is an example. According to an embodiment, the sensor may be driven in a resistive film method, an ultrasonic method, or an infrared method rather than the capacitive method, and it should not be particularly limited.

Each of the first conductive layer MTL1 and the second conductive layer MTL2 may include a transparent conductive oxide or may have a metal mesh shape formed of an opaque conductive material. The first conductive layer MTL1 and the second conductive layer MTL2 may include various materials and various shapes as long as a visibility of the image displayed by the light generated by the light emitting device layer is not deteriorated.

The third sensing insulating layer 73 may include an inorganic layer. The inorganic layer may include at least one of aluminium oxide, titanium oxide, silicon oxide, silicon nitride, silicon oxynitride, zirconium oxide, and hafnium oxide.

According to an embodiment, the third sensing insulating layer 73 may include an organic layer. The organic layer may include at least one of an acrylic-based resin, a methacrylic-based resin, a polyisoprene-based resin, a vinyl-based resin, an epoxy-based resin, a urethane-based resin, a cellulose-based resin, a siloxane-based resin, a polyimide-based resin, a polyamide-based resin, and a perylene-based resin.

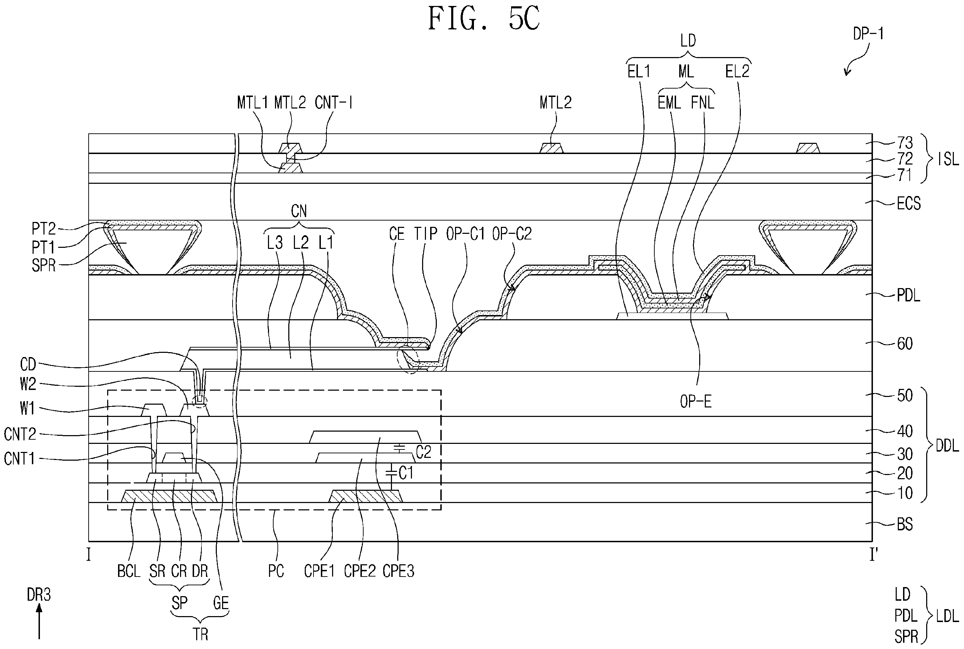

FIG. 5C is an enlarged schematic cross-sectional view of a display panel DP-1 taken along line I-I' of FIG. 4B according to an embodiment. Referring to FIG. 5C, a display panel DP-1 may include a base layer BS, a driving device layer DDL, a connection wiring CN, a sixth insulating layer 60, a light emitting device layer LDL, an encapsulation substrate ECS, and a sensing layer ISL. For example, according to an embodiment, the encapsulation substrate ECS may be disposed on the light emitting device layer LDL when compared with the display panel DP shown in FIG. 5A. The encapsulation substrate ECS may be disposed on a separator SPR. The encapsulation substrate ECS may be disposed to be in contact with a second separation pattern layer PT2 disposed on the separator SPR. The encapsulation substrate ECS may include a glass substrate.

The encapsulation substrate ECS may be attached to the base layer BS by a separate coupling member, for example, a frit, in the peripheral area NDA (refer to FIG. 3A). The encapsulation substrate ECS attached to the base layer BS may encapsulate the pixels and may prevent the pixels from being damaged due to external moisture. However, the method of attaching the encapsulation substrate ECS should not be limited thereto or thereby.

The sensing layer ISL may be disposed on the encapsulation substrate ECS. The sensing layer ISL may include first, second, and third sensing insulating layers 71 and 72, and 73 sequentially stacked each other on the encapsulation substrate ECS, a first conductive layer MTL1 disposed between the first and second sensing insulating layers 71 and 72, and second conductive layers MTL2 disposed between the second and third sensing insulating layers 72 and 73. According to an embodiment, the first sensing insulating layer 71 may be omitted, and the first conductive layer MTL1 may be disposed directly on the encapsulation substrate ECS.

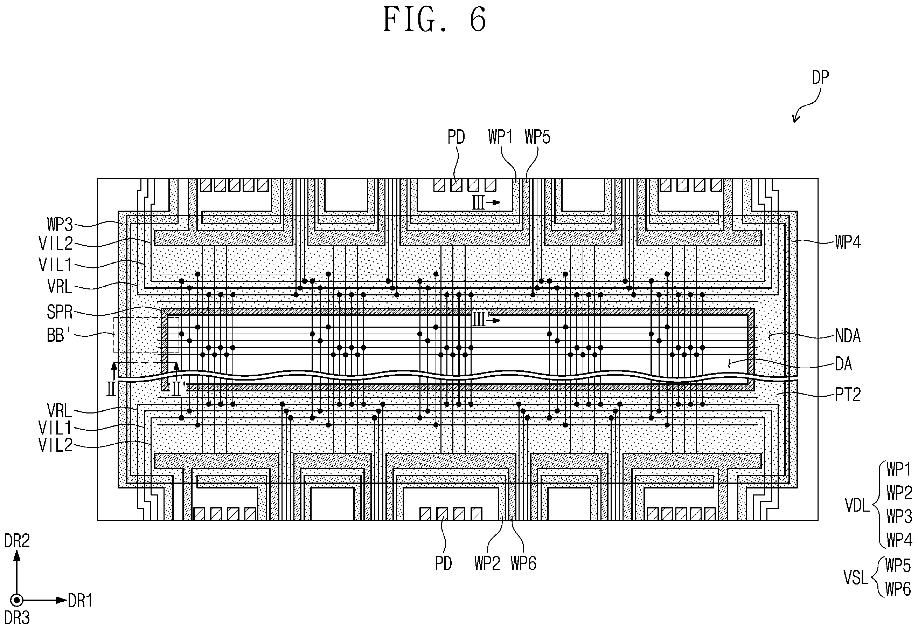

FIG. 6 is a schematic plan view of components of the display panel DP according to an embodiment. FIG. 6 is an enlarged schematic plan view of the power lines VDL, VSL, VIL1, VIL2, and VRL, the separator SPR, and a portion of the separation conductive layer PT2. The separation conductive layer PT2 described hereinafter may correspond to the second separation pattern layer PT2 described with reference to FIGS. 5A and 5B.

Referring to FIG. 6, the power lines VDL, VSL, VIL1, VIL2, and VRL provided with various constant voltages required for the display panel DP may pass through the peripheral area NDA. The power lines VDL, VSL, VIL1, VIL2, and VRL may be arranged to have a mesh structure in the display area DA to provide voltages to the pixels arranged over the display panel DP.

The power lines VDL, VSL, VIL1, VIL2, and VRL may include the first power line VDL, the second power line VSL, the fourth power line VIL1, the fifth power line VIL2, and the third power line VRL.

In an embodiment, the first power line VDL may include a first wiring part WP1, a second wiring part WP2, a third wiring part WP3, and a fourth wiring part WP4.

The first wiring part WP1 may be disposed at an upper side of the display area DA. For example, the first wiring part WP1 may be disposed spaced apart from the display area DA in the second direction DR2. The first wiring part WP1 may include patterns arranged in the first direction DR1. The patterns of the first wiring part WP1 may include a portion extending in the first direction DR1 and a portion extending from an end (both ends or one of both ends) of the portion in the second direction DR2.

The second wiring part WP2 may be disposed at a lower side of the display area DA. For example, the second wiring part WP2 may be disposed spaced apart from the display area DA in a direction opposite to the second direction DR2. The second wiring part WP2 may include patterns arranged in the first direction DR1. The patterns of the second wiring part WP2 may include a portion extending in the first direction DR1 and a portion extending from an end (both ends or one of both ends) of the portion to the direction opposite to the second direction DR2.

However, the shape of each of the patterns of the first wiring part WP1 and the patterns of the second wiring part WP2 should not be limited thereto or thereby. According to an embodiment, the first and second wiring parts WP1 and WP2 may be changed in various ways depending on a design of other lines in the peripheral area NDA and the shape and arrangement of the display area DA and the peripheral area NDA.

The third wiring part WP3 may be disposed at a left side of the display area DA. For example, the third wiring part WP3 may be disposed spaced apart from the display area DA to a direction opposite to the first direction DR1. The third wiring part WP3 may include a portion extending in the second direction DR2. The third wiring part WP3 may have a shape whose upper and lower ends are bent.

The fourth wiring part WP4 may be disposed at a right side of the display area DA. For example, the fourth wiring part WP4 may be disposed spaced apart from the display area DA in the first direction DR1. The fourth wiring part WP4 may include a portion extending in the second direction DR2. The fourth wiring part WP4 may have a shape whose upper and lower ends are bent.

However, the shape of each of the third wiring part WP3 and the fourth wiring part WP4 should not be limited thereto or thereby. According to an embodiment, the third and fourth wiring parts WP3 and WP4 may be changed in various ways depending on a design of other lines in the peripheral area NDA and the shape and arrangement of the display area DA and the peripheral area NDA.

In an embodiment, the second power line VSL may include a fifth wiring part WP5 and a sixth wiring part WP6.

The fifth wiring part WP5 may be disposed at the upper side of the display area DA. For example, the fifth wiring part WP5 may be disposed spaced apart from the display area DA in the second direction DR2. The fifth wiring part WP5 may include patterns arranged in the first direction DR1. The patterns of the fifth wiring part WP5 may include a portion extending in the first direction DR1 and portions extending from the portion in the second direction DR2. The patterns of the fifth wiring part WP5 may be disposed closer to the display area DA than the patterns of the first wiring part WP1 are. Each of the patterns of the fifth wiring part WP5 may be disposed to surround a portion of the patterns of the first wiring part WP1.

The sixth wiring part WP6 may be disposed at the lower side of the display area DA. For example, the sixth wiring part WP6 may be disposed spaced apart from the display area DA in the direction opposite to the second direction DR2. The sixth wiring part WP6 may include patterns arranged in the first direction DR1. The patterns of the sixth wiring part WP6 may include a portion extending in the first direction DR1 and portions extending from both ends of the portion in the direction opposite to the second direction DR2. The patterns of the sixth wiring part WP6 may be disposed closer to the display area DA than the patterns of the second wiring part WP2 are. Each of the patterns of the sixth wiring part WP6 may be disposed to surround a portion of the patterns of the second wiring part WP2.

However, the shape of each of the patterns of the fifth wiring part WP5 and the patterns of the sixth wiring part WP6 should not be limited thereto or thereby. According to an embodiment, the fifth and sixth wiring parts WP5 and WP6 may be changed in various ways depending on a design of other lines in the peripheral area NDA and the shape and arrangement of the display area DA and the peripheral area NDA.

A portion of each of the fourth power line VIL1, the fifth power line VIL2, and the third power line VRL may be disposed between the display area DA and the fifth wiring part WP5 and between the display area DA and the sixth wiring part WP6. Another portion of each of the fourth power line VIL1, the fifth power line VIL2, and the third power line VRL may be disposed between the first and third wiring parts WP1 and WP3, between the first and fourth wiring parts WP1 and WP4, between the second and third wiring parts WP2 and WP3, and between the second and fourth wiring parts WP2 and WP4. The other portion of each of the fourth power line VIL1, the fifth power line VIL2, and the third power line VRL may be disposed between the patterns of the fifth wiring part WP5, which are adjacent to each other, and between the patterns of the sixth wiring part WP6, which are adjacent to each other.

However, the arrangement of the fourth power line VIL1, the fifth power line VIL2, and the third power line VRL should not be limited thereto or thereby and may be changed in various ways depending on a design of other lines in the peripheral area NDA and the shape and arrangement of the display area DA and the peripheral area NDA.

The pads PD may be arranged in the peripheral area NDA along the first direction DR1 to be adjacent to an end of the peripheral area NDA. The pads PD may be electrically connected to a circuit board (not shown). Each of the pads PD may be connected to a corresponding data line among the data lines DL1 to DLm (refer to FIG. 1). The circuit board (not shown) may be electrically connected to the display panel DP and may provide signals to drive the display panel DP. As an example, the timing controller TC (refer to FIG. 1) may be mounted on the circuit board (not shown), the scan driver SDC (refer to FIG. 3A) may be included in the display panel DP, and the data driver DDC (refer to FIG. 3A) may be mounted on the display panel DP. The circuit board may control an operation of the scan driver SDC (refer to FIG. 3A) and the data driver DDC (refer to FIG. 3A).

In an embodiment, some or a number of the pads PD may be arranged to be adjacent to an upper end of the peripheral area NDA, and the other of the pads PD may be arranged to be adjacent to a lower end of the peripheral area NDA. The pads PD may be electrically connected to circuit boards (not shown). As an example, one circuit board may be connected to the pads PD arranged adjacent to the upper end of the peripheral area NDA, and the other one circuit board may be connected to the pads PD arranged adjacent to the lower end of the peripheral area NDA. However, the arrangement of the pads PD should not be limited thereto or thereby. According to an embodiment, the pads PD may be arranged to only one end of the peripheral area NDA, and, one circuit board may be electrically connected the pads PD.

FIG. 6 schematically shows only a portion forming an outer portion of the separator SPR. The portion forming the outer portion of the separator SPR shown in FIG. 6 may overlap the peripheral area NDA and may correspond to the other portion except the portion included in the light emitting unit described with reference to FIG. 4A. According to an embodiment, the outer portion of the separator SPR may have a quadrangular shape.

FIG. 6 shows only the portion of the separation conductive layer PT2, which is disposed in the peripheral area NDA. According to the disclosure, the separation conductive layer PT2 may be electrically connected to one of the first power line VDL and the second power line VSL. Accordingly, the separation conductive layer PT2 may receive the first power supply voltage VDD (refer to FIGS. 2A and 2B) from the first power line VDL, or the separation conductive layer PT2 may receive the second power supply voltage VSS (refer to FIGS. 2A and 2B) from the second power line VSL.

The separation conductive layer PT2 disposed in the peripheral area NDA may extend from the outer portion of the separator SPR to the first power line VDL when viewed in the plan view. The separation conductive layer PT2 may be electrically connected to the first power line VDL. According to an embodiment, the separation conductive layer PT2 may extend to only the second power line VSL, and the separation conductive layer PT2 may be electrically connected to the second power line VSL.

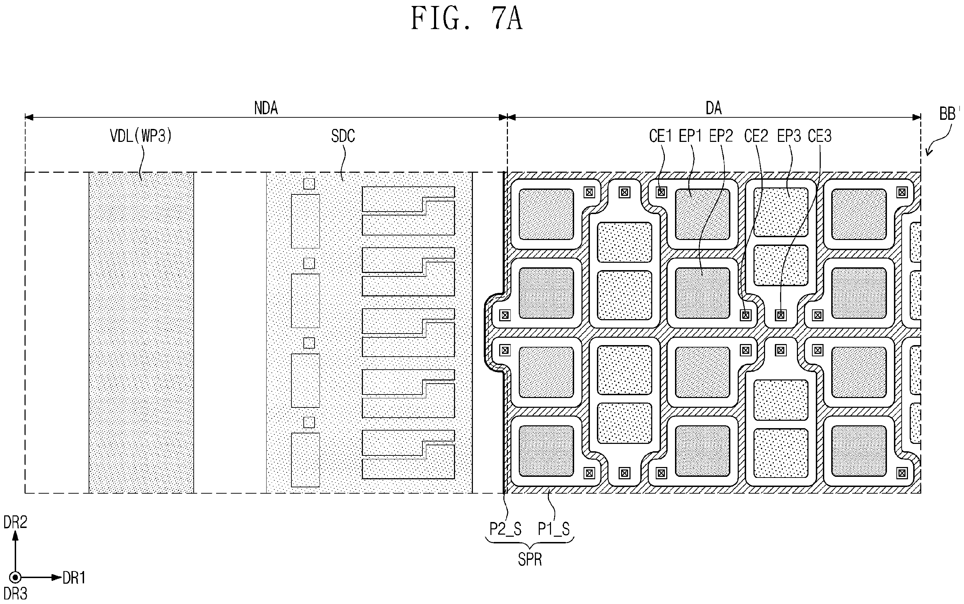

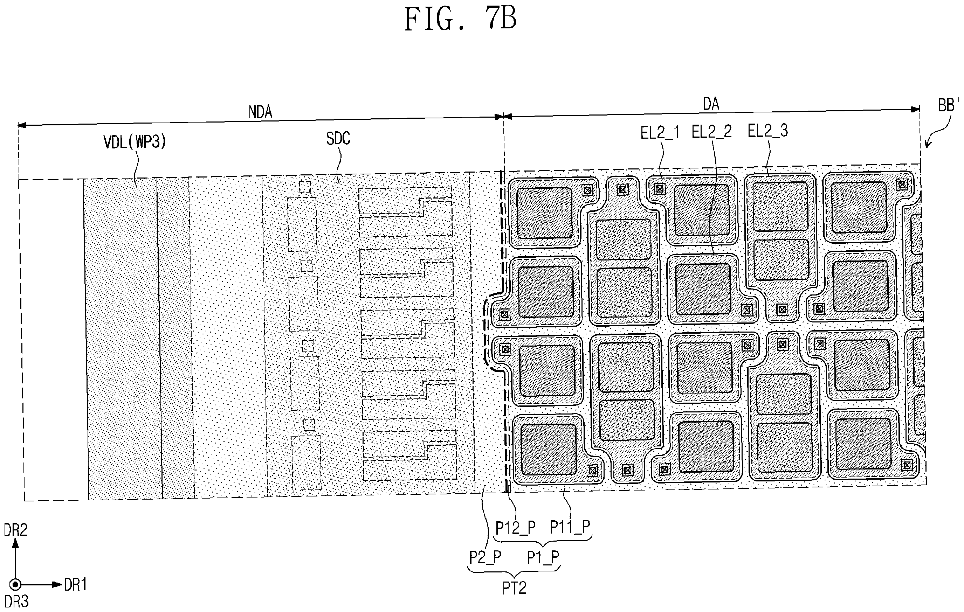

FIGS. 7A and 7B are enlarged schematic plan views of the display panel in an area BB' of FIG. 6 according to an embodiment. FIGS. 7A and 7B are enlarged views showing a boundary between the display area DA and the peripheral area NDA. FIG. 7A shows the separator SPR, the light emitting parts EP1, EP2, and EP3, and the emission connection parts CE1, CE2, and CE3, and FIG. 7B shows the second electrodes EL2_1, EL2_2, and EL2_3 and the separation conductive layer PT2. In FIGS. 7A and 7B, the same/similar reference numerals denote the same/similar elements in FIGS. 1 to 6, and thus, detailed descriptions of the same elements may be omitted.

Referring to FIG. 7A, the separator SPR may include an inner side portion P1_S and an outer portion P2_S. The inner side portion P1_S may correspond to a portion overlapping the display area DA. The inner side portion P1_S may be included in the light emitting units described with reference to FIG. 4A and may act to electrically disconnect the second electrodes EL2_1, EL2_2, and EL2_3.

The outer portion P2_S may correspond to a portion overlapping the peripheral area NDA. The outer portion P2_S may correspond to the other portion except the inner side portion P1_S and may not be included in the light emitting units. The outer portion P2_S may surround the inner side portion P1_S and may form the outer portion of the separator SPR. The separator SPR shown in FIG. 6 may correspond to the outer portion P2_S. In the disclosure, the inner side portion P1_S and the outer portion P2_S of the separator SPR are defined as being divided from each other for the convenience of explanation, however, they substantially form a single component.

According to the disclosure, an interior angle between at least a portion of an outer side surface of the separator SPR and the lower surface LS (refer to FIG. 5B) may be different from an interior angle between the inner side surface IS (refer to FIG. 5B) of the separator SPR and the lower surface LS (refer to FIG. 5B), and different from the inner side surface IS (refer to FIG. 5B), meaning that an electrical disconnection of the deposition layer may not occur in at least the portion of the outer side surface. This will be described in detail later.

FIGS. 7A and 7B show a portion adjacent to a left end of the display panel DP (refer to FIG. 6) as a representative example with the third wiring part WP3 of the first power line VDL extending in the second direction DR2 and the scan driver SDC disposed between the third wiring part WP3 and the display area DA.

Referring to FIGS. 7A and 7B, the separation conductive layer PT2 may include a first portion P1_P and a second portion P2_P.

The first portion P1_P may be disposed on the separator SPR. In the disclosure, the expression "a component is disposed on the separator" may mean that the component is disposed to directly or indirectly cover the inner side surface IS (refer to FIG. 5B) and the outer side surface of the separator SPR as well as being disposed on the upper surface US (refer to FIG. 5B) of the separator SPR.

The first portion P1_P may include a first sub-portion P11_P disposed in the display area DA and a second sub-portion P12_P disposed in the peripheral area NDA. For example, the first sub-portion P11_P may be disposed on the inner side portion P1_S (refer to FIG. 5B) of the separator SPR, and the second sub-portion P12_P may be disposed on the outer portion P2_S of the separator SPR. The first portion P1_P may have substantially the same shape as the separator SPR when viewed in the plan view. The second separation pattern layer PT2 described with reference to FIGS. 5A and 5B may correspond to the first sub-portion P11_P.

FIG. 7B shows the second electrodes EL2_1, EL2_2, and EL2_3 disconnected by the separator SPR. The second electrodes EL2_1, EL2_2, and EL2_3 may be disposed for each pixel after being divided into portions by the separator SPR, and the separation conductive layer PT2 may be disconnected from the second electrodes EL2_1, EL2_2, and EL2_3 by the separator SPR.

The second portion P2_P may not be in contact with the separator SPR. The second portion P2_P may be disposed in the peripheral area NDA.

The second portion P2_P may extend from the boundary between the display area DA and the peripheral area NDA to the first power line VDL. The second portion P2_P may overlap the scan driver SDC. However, since FIG. 7B shows the portion adjacent to the left end of the display panel DP, a circuit overlapping the second portion P2_P may vary according to circuit configurations disposed between the display area DA and the first power line VDL in a portion adjacent to the other end of the display panel DP. As an example, the second portion P2_P may overlap the fourth power line VIL1 (refer to FIG. 6), the fifth power line VIL2 (refer to FIG. 6), and the third power line VRL (refer to FIG. 6), and the second portion P2_P may also overlap the second power line VSL (refer to FIG. 6).

The second portion P2_P may be electrically connected to the first power line VDL. The second portion P2_P may receive the first power supply voltage VDD (refer to FIGS. 2A and 2B) from the first power line VDL, and the first power supply voltage VDD (refer to FIGS. 2A and 2B) may be provided to the first portion P1_P via the second portion P2_P.Accordingly, the constant voltage may be provided to the first portion P1_P, and thus, the separation conductive layer PT2 may not be provided in a floating state on the separator SPR. Therefore, an electrical interference of the separation conductive layer PT2, which reaches the light emitting device LD (refer to FIG. 5A), may be reduced, and an error in driving current of the light emitting device LD (refer to FIG. 5A) may be reduced. As the electrical reliability of the light emitting device LD (refer to FIG. 5A) is improved, defects in display quality of the display panel DP (refer to FIG. 5A) may be reduced. An electrical interference of the separation conductive layer PT2, which reaches the sensing layer ISL (refer to FIG. 5A), may be reduced, and thus, the sensing reliability of the display panel DP (refer to FIG. 5A) may be improved.

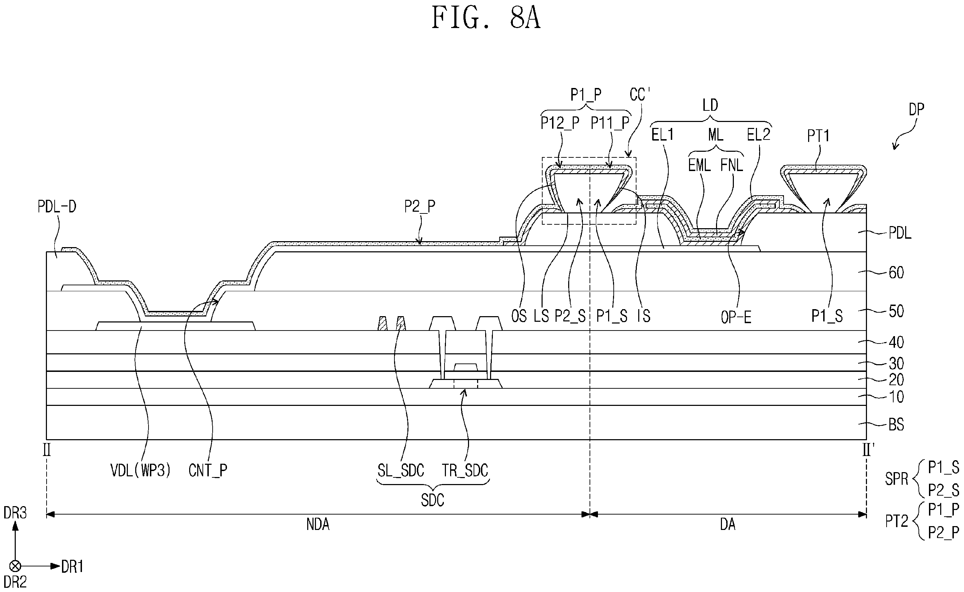

The connection between the second portion P2_P and the first power line VDL will be described in detail below with reference to FIGS. 8A to 8D.

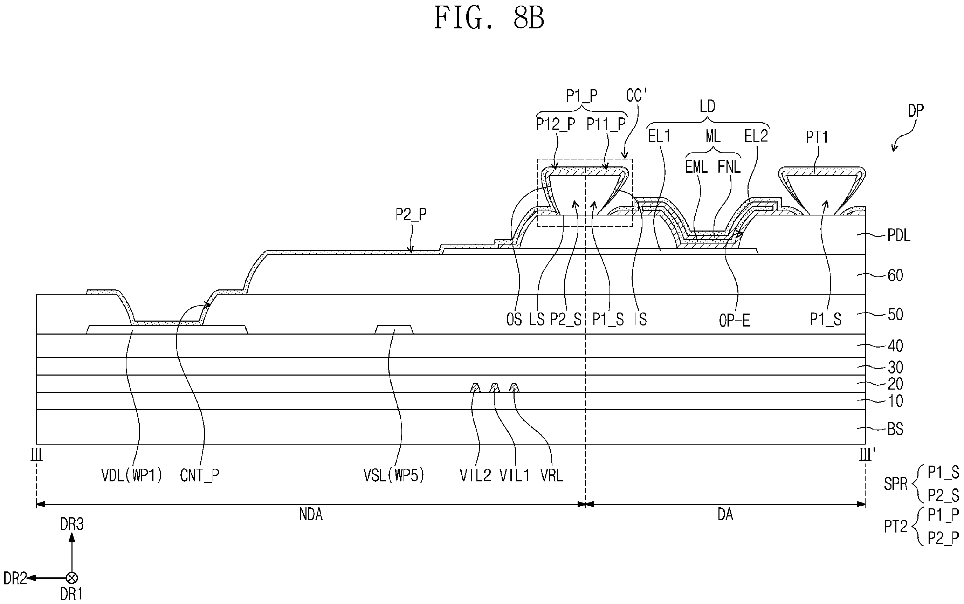

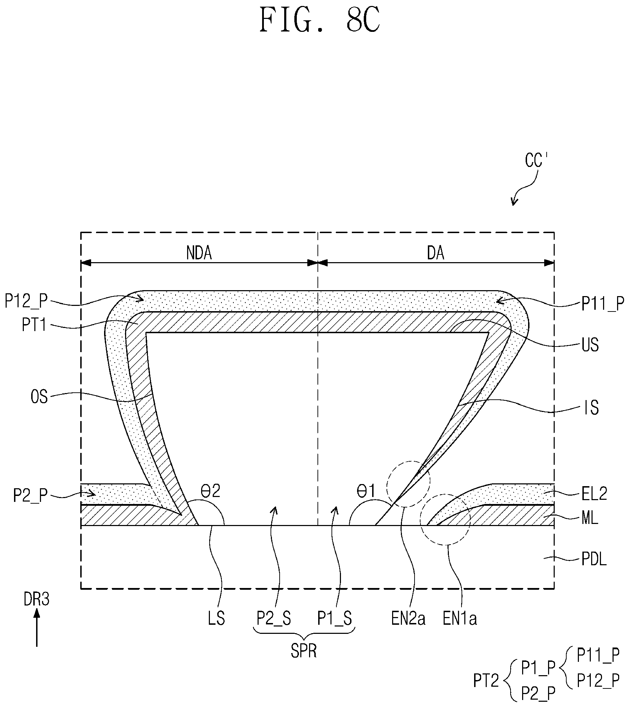

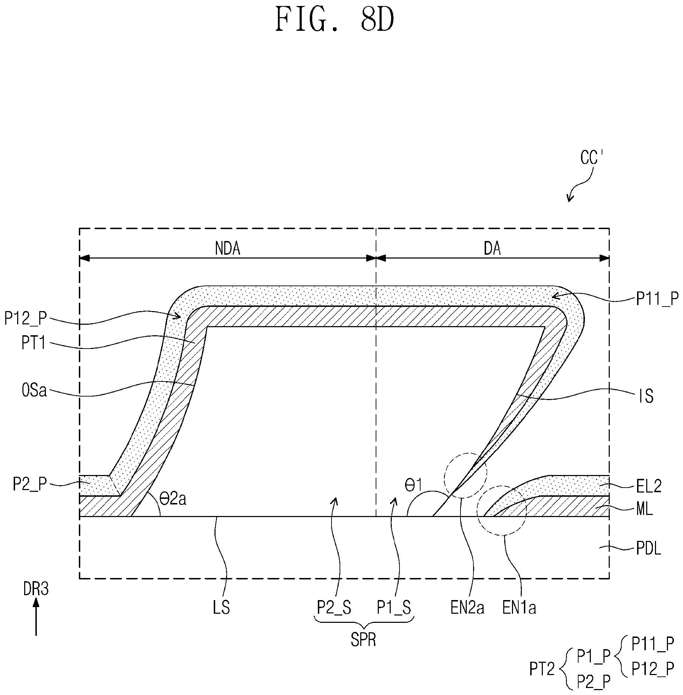

FIG. 8A is an enlarged schematic cross-sectional view of the display panel DP taken along line II-II' of FIG. 6 according to an embodiment. FIG. 8B is an enlarged schematic cross-sectional view of the display panel DP taken along line III-III' of FIG. 6 according to an embodiment. FIG. 8C is an enlarged schematic cross-sectional view of an area CC' of FIGS. 8A and 8B according to an embodiment. FIG. 8D is an enlarged schematic cross-sectional view of an area CC' of FIGS. 8A and 8B according to an embodiment.

FIG. 8A shows the cross-section at a left end portion of the display area DA and the peripheral area NDA adjacent to the left end portion of the display area DA, for example, a left end portion of the display panel DP. FIG. 8B shows the cross-section at an upper end portion of the display area DA and a peripheral area NDA adjacent to the upper end portion of the display area DA, for example, an upper end portion of the display panel DP.

Referring to FIG. 8A, the first power line VDL may be disposed on the fourth insulating layer 40. At least a portion of the first power line VDL may be exposed via a contact hole CNT_P defined through the fifth insulating layer 50. However, the disclosure should not be limited thereto or thereby, and according to an embodiment, the first power line VDL may be disposed on the fifth insulating layer 50. According to an embodiment, the first power line VDL may include a first line disposed on the fourth insulating layer 40 and a second line disposed on the fifth insulating layer 50, and the first line and the second line may be electrically connected to each other via a contact hole defined through the fifth insulating layer 50.

In a cross-section viewed in the second direction DR2, the first electrode EL1 may extend from the display area DA to the third wiring part WP3 of the first power line VDL and may be connected to the third wiring part WP3. For example, the first electrode EL1 may be directly connected to the third wiring part WP3 via the contact hole CNT_P in the left end portion of the display panel DP. Descriptions on this structure may be similarly applied to a right end portion of the display panel DP, and the first electrode EL1 may be connected to the fourth wiring part WP4 (refer to FIG. 6).

In an embodiment, the display panel DP may further include a dummy insulating layer PDL-D. The dummy insulating layer PDL-D may cover an end portion of the first electrode EL1, which is connected to the first power line VDL.

An interior angle between an outer side surface OS and the lower surface LS of the separator SPR is different from an interior angle between the inner side surface IS and the lower surface LS of the separator SPR. The interior angle between the outer side surface OS and the lower surface LS is smaller than the interior angle between the inner side surface IS and the lower surface LS.

Accordingly, an end of the first separation pattern layer PT1 disposed on the inner side portion P1_S of the separator SPR may be electrically disconnected from the intermediate layer ML adjacent thereto, however, the first separation pattern layer PT1 disposed on the outer portion P2_S of the separator SPR may extend to the outside of the separator SPR along the outer side surface OS.

FIG. 8A shows a structure in which the first separation pattern layer PT1 covers an end of the pixel definition layer PDL as a representative example, however, the disclosure should not be limited thereto or thereby. According to an embodiment, the first separation pattern layer PT1 may not cover the end of the pixel definition layer PDL or may further cover an upper surface of the sixth insulating layer 60 exposed without being covered by the pixel definition layer PDL. According to an embodiment, the first separation pattern layer PT1 may extend to an area adjacent to the first power line VDL.

The separation conductive layer PT2 may also have substantially similar shape to that of the first separation pattern layer PT1. For example, an end of the separation conductive layer PT2 disposed on the inner side portion P1_S may be electrically disconnected from the second electrode EL2 adjacent thereto, however, the separation conductive layer PT2 disposed on the outer portion P2_S may extend to the outside of the separator SPR along the outer side surface OS. The second sub-portion P12_P of the separation conductive layer PT2 and the second portion P2_P of the separation conductive layer PT2 may be partially connected to each other. In other words, the second portion P2_P may extend from the first portion P1_P.

The second portion P2_P may extend from the first portion P1_P to the first power line VDL. In a cross-section viewed in the second direction DR2, the second portion P2_P may be in contact with the first electrode EL1 but may not be in contact with the third wiring part WP3 of the first power line VDL. Accordingly, the separation conductive layer PT2 may receive the first power supply voltage VDD (refer to FIGS. 2A and 2B) via the first electrode EL1 in the left end portion of the display panel DP. Descriptions on this structure may be similarly applied to the right end portion of the display panel DP, and the separation conductive layer PT2 may not be in contact with the fourth wiring part WP4 (refer to FIG. 6).

The second portion P2_P may overlap the scan driver SDC in the left end portion of the display panel DP. FIG. 8A shows a transistor TR_SDC (hereinafter, referred to as a scan transistor) and signal lines SL_SDC (hereinafter, referred to as scan signal lines) included in the scan driver SDC as a representative example, however, the arrangement of the scan transistor TR_SDC and the scan signal lines SL_SDC should not be limited thereto or thereby.

Referring to FIG. 8B, in the cross-section viewed in the first direction DR1, the first electrode EL1 may not be in contact with the first wiring part WP1 of the first power line VDL. For example, the first electrode EL1 may not extend to the first wiring part WP1 in the upper end portion of the display panel DP.

In the cross-section viewed in the first direction DR1, the second portion P2_P of the separation conductive layer PT2 may extend from the first portion P1_P to the first wiring part WP1 of the first power line VDL and may be in contact with the first wiring part WP1. For example, the second portion P2_P may be connected to the first wiring part WP1 via the contact hole CNT_P defined through the fifth insulating layer 50 in the upper end portion of the display panel DP.

Accordingly, a portion of the second portion P2_P may be in contact with the first electrode EL1 in the upper end portion of the display panel DP, and the first electrode EL1 may receive the first power supply voltage VDD (refer to FIGS. 2A and 2B) through the second portion P2_P. Descriptions on this structure may be similarly applied to the lower end portion of the display panel DP. Thus, the first electrode EL1 may not be in contact with the second wiring part WP2 (refer to FIG. 6), and the second portion P2_P may be in contact with the second wiring part WP2 (refer to FIG. 6). FIG. 8B shows a second power line VSL disposed between the first power line VDL and the display area DA and other power lines VIL1, VIL2, and VRL. As the second portion P2_P extends from the first portion P1_P to the first wiring part WP1 in the upper end portion of the display panel DP, the second portion P2_P may overlap the second power line VSL and the other power lines VIL1, VIL2, and VRL, however, the disclosure should not be limited thereto or thereby. According to an embodiment, the second portion P2_P may not overlap the second power line VSL and the other power lines VIL1, VIL2, and VRL according to a design of the second power line VSL and the other power lines VIL1, VIL2, and VRL.

FIG. 8B shows a structure in which the second power line VSL is disposed on the fourth insulating layer 40 as a representative example, however, the disclosure should not be limited thereto or thereby. The second power line VSL may be provided in a multi-layer structure together with additional lines disposed on the first insulating layer 10 or may be disposed on another insulating layer.

The other power lines VIL1, VIL2, and VRL may correspond to the fourth power line VIL1, the fifth power line VIL2, and the third power line VRL. FIG. 8B shows the structure in which the other power lines VIL1, VIL2, and VRL are disposed on the first insulating layer 10 as a representative example, however, the disclosure should not be limited thereto or thereby. The other power lines VIL1, VIL2, and VRL may be disposed on another insulating layer, or the other power lines VIL1, VIL2, and VRL may be disposed on different layers from each other.

FIGS. 8C and 8D are enlarged schematic cross-sectional views of the outer portion P2_S and the inner side portion P1_S adjacent to the outer portion P2_S of the separator SPR.

Referring to FIG. 8C, an interior angle θ2 between the outer side surface OS and the lower surface LS of the separator SPR is smaller than the interior angle θ1 between the inner side surface IS and the lower surface LS, and the interior angle θ2 between the outer side surface OS and the lower surface LS may be equal to or greater than about 90 degrees.

The interior angle θ2 between the outer side surface OS and the lower surface LS may be set to allow the second sub-portion P12_P of the separation conductive layer PT2 to be deposited from one end of the outer side surface OS connected to the upper surface US to the other end of the outer side surface OS connected to the lower surface LS. The interior angle θ2 between the outer side surface OS and the lower surface LS may be set to allow the second sub-portion P12_P to be deposited on the outer side surface OS with a sufficient thickness and the second sub-portion P12_P may be electrically connected to the second portion P2_P.

The interior angle θ2 between the outer side surface OS and the lower surface LS may be adjusted by an exposure process in a process of forming the separator SPR using a photolithography process. In detail, in a process of irradiating a light to a preliminary separator coated with a material of the separator SPR, an amount of the light provided to an area where the outer side surface OS is formed may be greater than an amount of the light provided to an area where the inner side surface IS is formed. According to an embodiment, a halftone mask may be used in order to provide a different amount of the light for each area.

Referring to FIG. 8D, an interior angle θ2a between an outer side surface OSa and the lower surface LS is smaller than the interior angle θ1 between the inner side surface IS and the lower surface LS, and the interior angle θ2a between the outer side surface OSa and the lower surface LS may be smaller than about 90 degrees.

Accordingly, the second sub-portion P12_P of the separation conductive layer PT2 may be deposited from one end of the outer side surface OSa connected to the upper surface US to the other end of the outer side surface OSa connected to the lower surface LS. The second sub-portion P12_P may be deposited on the outer side surface OSa with a sufficient thickness and may be electrically connected to the second portion P2_P.

As described above, the separation conductive layer PT2 may be electrically connected to the second power line VSL (refer to FIG. 6). Similarly, as the interior angles θ2 and θ2a between the outer side surface OS and OSa and the lower surface LS of the separator SPR are adjusted, the first portion P1_P and the second portion P2_P of the separation conductive layer PT2 may be electrically connected to each other. The separation conductive layer PT2 may be in contact with the second power line VSL (refer to FIG. 6) via a contact hole defined through at least one insulating layer, and thus, may be electrically connected to the second power line VSL (refer to FIG. 6). To this end, the separation conductive layer PT2 may be disposed to be electrically insulated from the first electrode EL1 that is electrically connected to the first power line VDL (refer to FIG. 6).

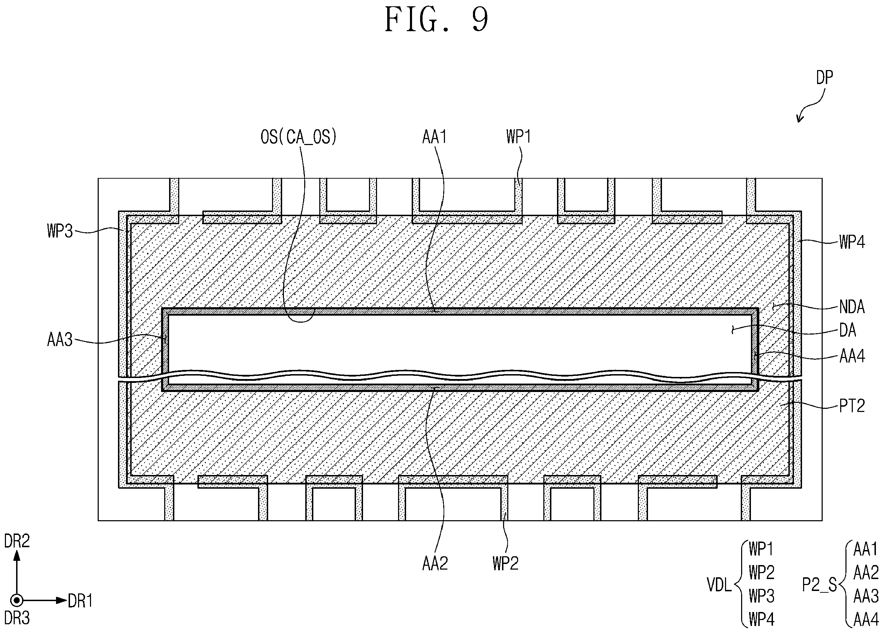

FIG. 9 is a schematic plan view of the display panel DP according to an embodiment. FIG. 9 shows the first power line VDL, the separator SPR (refer to FIG. 7A), and the separation conductive layer PT2, and only the outer portion P2_S of the separator SPR (refer to FIG. 7A) and the second sub-portion P12_P (refer to FIG. 7B) and the second portion P2_P (refer to FIG. 7B) of the separation conductive layer PT2, which are disposed in the peripheral area NDA, are schematically illustrated. In FIG. 9, the same/similar reference numerals denote the same/similar elements in FIGS. 6 to 8D, and thus, detailed descriptions of the same/similar elements may be omitted.

Referring to FIGS. 7A, 7B, and 9, the outer portion P2_S of the separator SPR may have a quadrangular shape when viewed in the plan view. The outer portion P2_S may include a first area AA1, a second area AA2, a third area AA3, and a fourth area AA4.

Each of the first and second areas AA1 and AA2 may extend in the first direction DR1, and the first and second areas AA1 and AA2 may be spaced apart from each other in the second direction DR2. Each of the third and fourth areas AA3 and AA4 may extend in the second direction DR2, and the third and fourth areas AA3 and AA4 may be spaced apart from each other in the first direction DR1. The third and fourth areas AA3 and AA4 may respectively extend from both ends of the first area AA1 to both ends of the second area AA2.

In an embodiment, the interior angle (refer to θ2 of FIG. 8C or θ2a of FIG. 8D) between the outer side surface OS and the lower surface LS (refer to FIGS. 8C and 8D) of the separator SPR is smaller than the interior angle θ1 (refer to FIGS. 8C and 8D) between the inner side surface IS (refer to FIGS. 8C and 8D) and the lower surface LS (refer to FIGS. 8C and 8D). In other words, the outer side surface OS of the separator SPR may be provided in the structure described with reference to FIGS. 8C or 8D in the entire area thereof. Accordingly, the separation conductive layer PT2 according to an embodiment may cover the entire area of the outer side surface OS.

The second portion P2_P of the separation conductive layer PT2 may be entirely connected to one end of the second sub-portion P12_P without being spaced apart from the second sub-portion P12_P. For example, the second portion P2_P may extend from the entire area of the first portion P1_P. In an embodiment, the outer side surface OS may include only a connection area CA_OS.

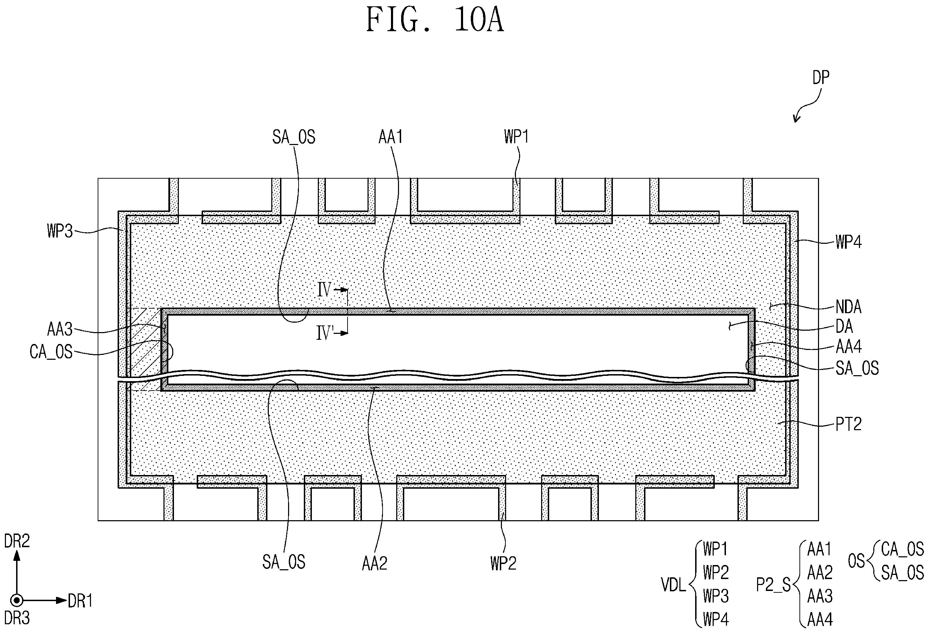

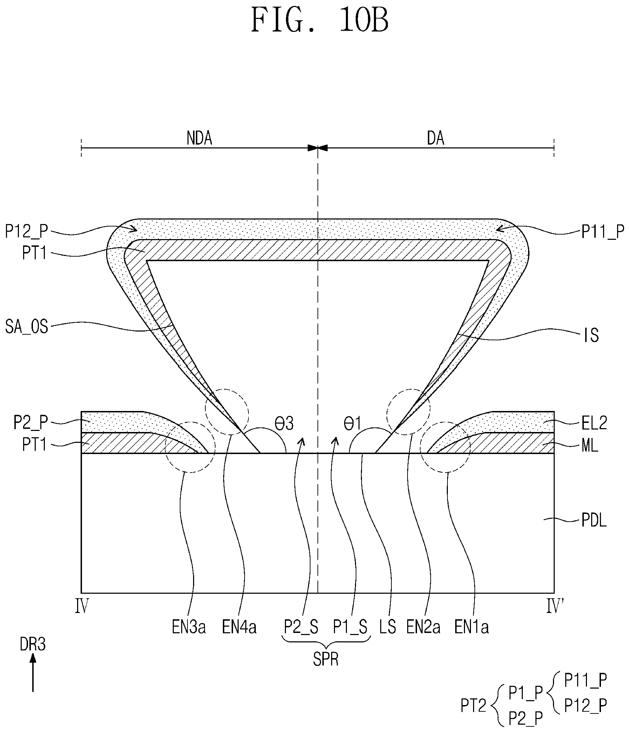

FIG. 10A is a schematic plan view of a display panel DP according to an embodiment. FIG. 10B is an enlarged schematic cross-sectional view of the display panel DP taken along line IV-IV' of FIG. 10A according to an embodiment. In FIGS. 10A and 10B, the same/similar reference numerals denote the same/similar elements in FIG. 9, and thus, detailed descriptions of the same/similar elements may be omitted.

Referring to FIGS. 7A, 7B, and 10A, an outer portion P2_S of a separator SPR may include first, second, third, and fourth areas AA1, AA2, AA3, and AA4.

In an embodiment, an outer side surface OS of the separator SPR may include a connection area CA_OS and a separation area SA_OS. For example, the outer side surface OS may further include the separation area SA_OS. In FIG. 10A, a portion of the outer portion P2_S, which may include the connection area CA_OS, is illustrated by a bold line, and a portion of the outer portion P2_S, which may include the separation area SA_OS, is illustrated by a relatively thin line.

The connection area CA_OS may have the structure described with reference to FIG. 8C or 8D, and when viewed in a cross-section, a second sub-portion P12_P of a separation conductive layer PT2 disposed on the connection area CA_OS may be connected to a second portion P2_P. On the other hand, the second sub-portion P12_P of the separation conductive layer PT2 disposed on the separation area SA_OS when viewed in the cross-section may be separated from the second portion P2_P.

Referring to FIG. 10B, an interior angle θ3 between the separation area SA_OS and a lower surface LS may be greater than the interior angle (refer to θ2 of FIG. 8C or θ2a of FIG. 8D) between the connection area CA_OS and the lower surface LS. As an example, the interior angle θ3 between the separation area SA_OS and the lower surface LS may be substantially the same as an interior angle θ1 between an inner side surface IS and the lower surface LS, however, it should not be limited thereto or thereby.

A third end portion EN3a and a fourth end portion EN4a may be formed in a deposition layer deposited on the separation area SA_OS. The third end portion EN3a may be spaced apart from the separator SPR and may be disposed on a pixel definition layer PDL. The fourth end portion EN4a may be spaced apart from the third end portion EN3a and may cover the separation area SA_OS. Accordingly, a first portion P1_P and the second portion P2_P of the separation conductive layer PT2 may be separated on the separation area SA_OS.

In an embodiment, as the first portion P1_P of the separation conductive layer PT2 has an integral shape, a constant voltage may be applied to the entire area of the first portion P1_P as long as a portion where the first portion P1_P is electrically connected to the second portion P2_P is provided. Accordingly, although the outer side surface OS of the separator SPR may include a portion of the separation area SA_OS and a portion of the first portion P1_P is separated from the second portion P2_P, the constant voltage may be applied to the other portion of the first portion P1_P electrically connected to the second portion P2_P. The first portion P1_P and the second portion P2_P, which are separated in the separation area SA_OS, may be electrically connected to each other, and the constant voltage may be provided to the entire area of the first portion P1_P. Accordingly, an electrical interference of the separation conductive layer PT2 to the light emitting device LD (refer to FIG. 5A) and the sensing layer ISL (refer to FIG. 5A) may be reduced.

Referring to FIG. 10A again, the outer side surface OS included in one area of the first, second, third, and fourth areas AA1, AA2, AA3, and AA4 may include only the connection area CA_OS, and the outer side surface OS included in the other of the first, second, third, and fourth areas AA1, AA2, AA3, and AA4 except the one area may include only the separation area SA_OS.

FIG. 10A shows the structure in which the outer side surface OS included in the third area AA3 may include only the connection area CA_OS and the outer side surface OS included in each of the first, second, and fourth areas AA1, AA2, and AA4 may include only the separation area SA_OS as a representative example, however, the disclosure should not be limited thereto or thereby. According to an embodiment, the outer side surface OS included in two areas of the first, second, third, and fourth areas AA1, AA2, AA3, and AA4 may include only the connection area CA_OS, or the outer side surface OS included in three areas of the first, second, third, and fourth areas AA1, AA2, AA3, and AA4 may include only the connection area CA_OS.

In FIG. 10A, a portion of the separation conductive layer PT2 that may include the first portion P1_P and the second portion P2_P connected to the first portion P1_P through the connection area CA_OS and that extends continuously from the outer portion P2_S of the separator SPR in a direction away from a display area DA is illustrated by hatching.

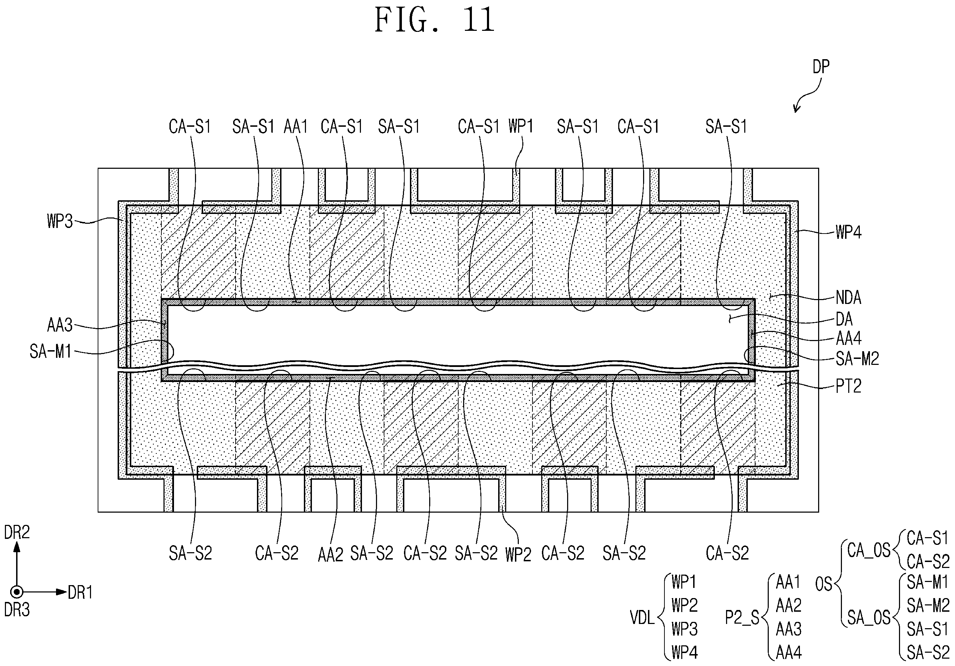

FIG. 11 is a schematic plan view of a display panel according to an embodiment. In FIG. 11, the same/similar reference numerals denote the same/similar elements in FIGS. 9 to 10B, and thus, detailed descriptions of the same/similar elements may be omitted.

Referring to FIGS. 7A, 7B, and 11, an outer portion P2_S of a separator SPR may include first, second, third, and fourth areas AA1, AA2, AA3, and AA4, and an outer side surface OS of the separator SPR may include a connection area CA_OS and a separation area SA_OS.

The connection area CA_OS may include first sub-connection areas CA-S1 and second sub-connection areas CA-S2. The separation area SA_OS may include a first main separation area SA-M1, a second main separation area SA-M2, first sub-separation areas SA-S1, and second sub-separation areas SA-S2.

The outer side surface OS included in the third area AA3 may include only the first main separation area SA-M1, and the outer side surface OS included in the fourth area AA4 may include only the second main separation area SA-M2.

The outer side surface OS included in the first area AA1 may include the first sub-connection areas CA-S1 and the first sub-separation areas SA-S1. The first sub-connection areas CA-S1 and the first sub-separation areas SA-S1 may be alternately arranged with each other in the first direction DR1.

The outer side surface OS included in the second area AA2 may include the second sub-connection areas CA-S2 and the second sub-separation areas SA-S2. The second sub-connection areas CA-S2 and the second sub-separation areas SA-S2 may be alternately arranged with each other in the first direction DR1.

FIG. 11 shows the structure in which each of the first sub-connection areas CA-S1 is disposed between the second sub-connection areas CA-S2 adjacent to each other when viewed in the second direction DR2 as a representative example, however, the disclosure should not be limited thereto or thereby. According to an embodiment, when viewed in the second direction DR2, the first sub-connection areas CA-S1 may respectively overlap the second sub-connection areas CA-S2.

In FIG. 11, a portion of a separation conductive layer PT2 that may include the first portion P1_P and the second portion P2_P connected to the first portion P1_P through the connection area CA_OS and that extends continuously from the outer portion P2_S in a direction away from a display area DA is illustrated by hatching.

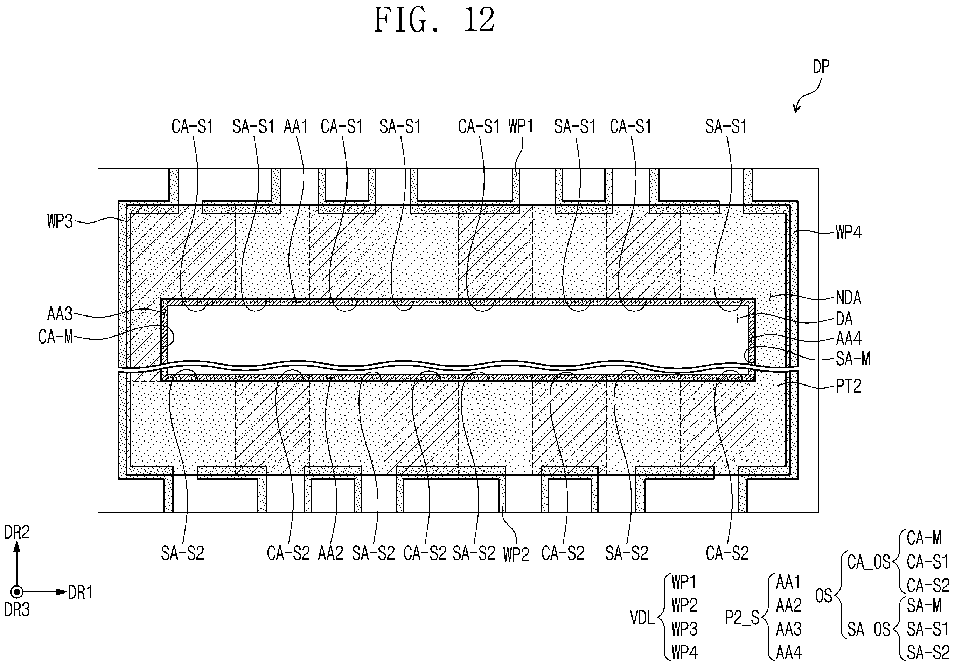

FIG. 12 is a schematic plan view of a display panel according to an embodiment. In FIG. 12, the same/similar reference numerals denote the same/similar elements in FIGS. 9 to 10B, and thus, detailed descriptions of the same/similar reference may be omitted.

Referring to FIGS. 7A, 7B, and 12, an outer portion P2_S of a separator SPR may include first, second, third, and fourth areas AA1, AA2, AA3, and AA4, and an outer side surface OS of the separator SPR may include a connection area CA_OS and a separation area SA_OS.

The connection area CA_OS may include a main connection area CA-M, first sub-connection areas CA-S1, and second sub-connection areas CA-S2. The separation area SA_OS may include a main separation area SA-M, first sub-separation areas SA-S1, and second sub-separation areas SA-S2.

The outer side surface OS included in the third area AA3 may include only the main connection area CA-M, and the outer side surface OS included in the fourth area AA4 may include only the main separation area SA-M, however, the disclosure should not be limited thereto or thereby. According to an embodiment, the outer side surface OS included in the fourth area AA4 may include the main connection area CA-M, and the outer side surface OS included in the third area AA3 may include only the main separation area SA-M.

The outer side surface OS included in the first area AA1 may include the first sub-connection areas CA-S1 and the first sub-separation areas SA-S1. The first sub-connection areas CA-S1 may be alternately arranged with the first sub-separation areas SA-S1 in the first direction DR1.

The outer side surface OS included in the second area AA2 may include the second sub-connection areas CA-S2 and the second sub-separation areas SA-S2. The second sub-connection areas CA-S2 may be alternately arranged with the second sub-separation areas SA-S2 in the first direction DR1.

FIG. 12 shows a structure in which each of the first sub-connection areas CA-S1 is disposed between the second sub-connection areas CA-S2 adjacent to each other when viewed in the second direction DR2 as a representative example, however, the disclosure should not be limited thereto or thereby. According to an embodiment, when viewed in the second direction DR2, the first sub-connection areas CA-S1 may be arranged to respectively overlap the second sub-connection areas CA-S2.

In FIG. 12, a portion of a separation conductive layer PT2 that may include a first portion P1_P and a second portion P2_P connected to the first portion P1_P through the connection area CA_OS and that extends continuously from the outer portion P2_S in a direction away from a display area DA is illustrated by hatching.

The disclosure should not be limited to the embodiments described with reference to FIGS. 9 to 12, and the position and size of the connection area CA_OS should not be particularly limited as long as the constant voltage is provided to the first portion P1_P by providing the portion where the first portion P1_P is connected to the second portion P2_P.

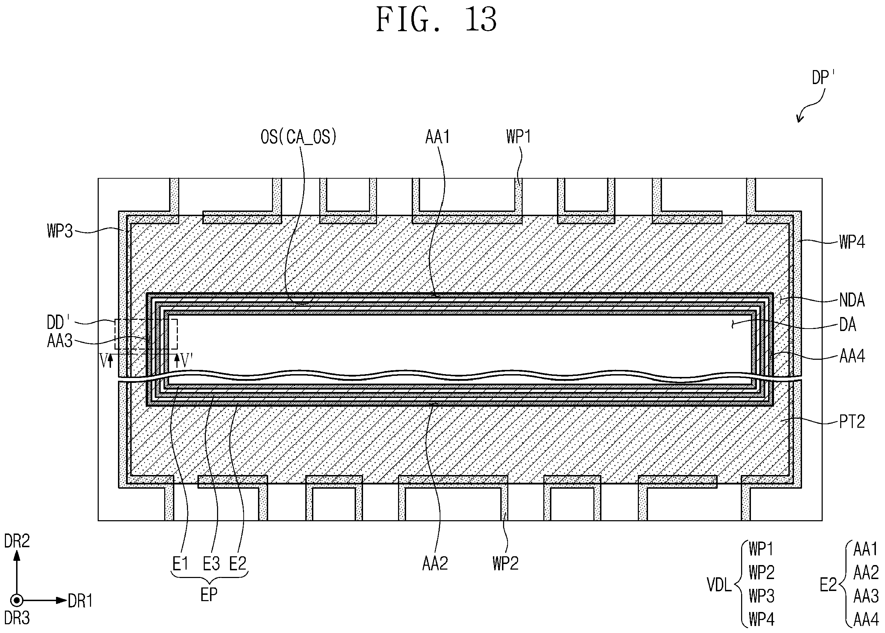

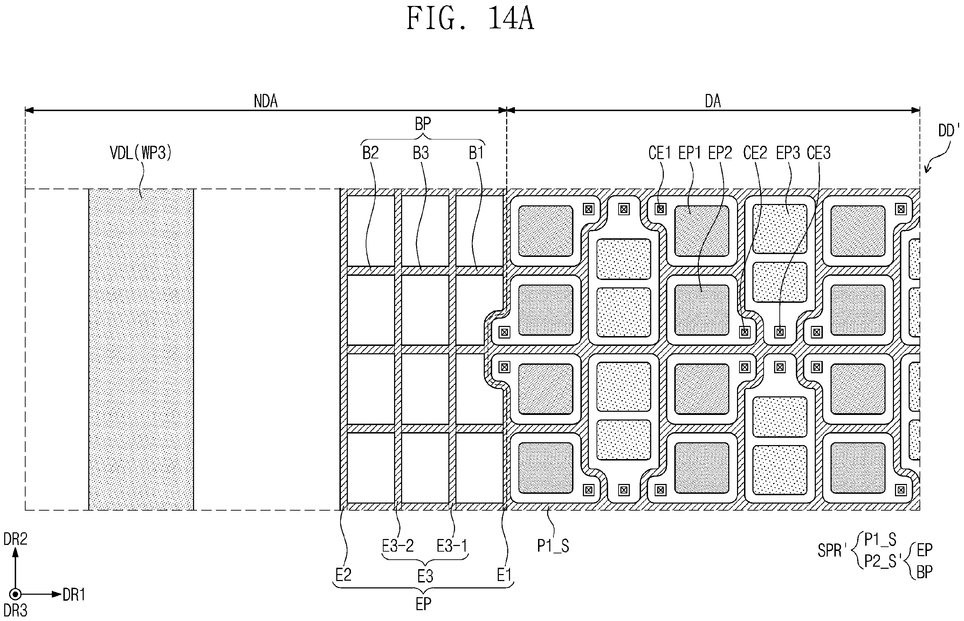

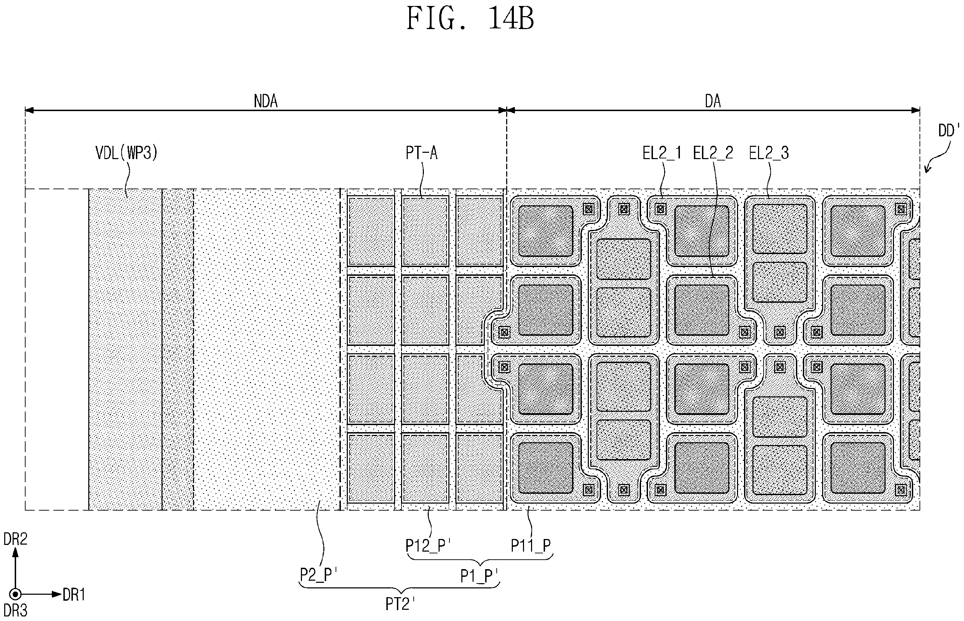

FIG. 13 is a schematic plan view of a display panel DP' according to an embodiment. FIGS. 14A and 14B are enlarged schematic plan views of an area DD' of FIG. 13 according to an embodiment. FIGS. 14A and 14B are enlarged views of a boundary between a display area DA and a peripheral area NDA. FIG. 14A shows a separator SPR', light emitting parts EP1, EP2, and EP3, and emission connection parts CE1, CE2, and CE3, and FIG. 14B shows second electrodes EL2_1, EL2_2, and EL2_3, a separation conductive layer PT2', and an additional separation pattern layer PT-A. In FIGS. 13, 14A, and 14B, the same/similar reference numerals denote the same/similar elements in FIGS. 1 to 12, and thus, detailed descriptions of the same/similar elements may be omitted.

Referring to FIG. 13 and 14A, the separator SPR' may include an inner side portion P1_S overlapping the display area DA and an outer portion P2_S' overlapping the peripheral area NDA. The outer portion P2_S' may include extension portions EP and bridge portions BP.

For the convenience of explanation, FIG. 13 schematically shows the extension portions EP of the outer portion P2_S'. As shown in FIG. 13, each of the extension portions EP may surround the display area DA when viewed in the plan view. According to an embodiment, the extension portions EP may include a first extension portion E1, a second extension portion E2, and a third extension portion E3. The first extension portion E1 may be a portion of the extension portions EP, which is adjacent to the display area DA and is disposed at an innermost position. The second extension portion E2 may be a portion of the extension portions EP, which surrounds the first extension portion E1 and is disposed at an outermost position. Accordingly, the second extension portion E2 may include an outer side surface OS of the separator SPR'.

The third extension portion E3 may be disposed between the first extension portion E1 and the second extension portion E2, may surround the first extension portion E1, and may be surrounded by the second extension portion E2. In FIG. 13, one third extension portion E3 is shown as a representative example, however, the disclosure should not be particularly limited. As an example, third extension portions E3, for example, two third extension portions E3 (hereinafter, referred to as third-first and third-second extension portions E3-1 and E3-2) may be provided as shown in FIG. 14A, or according to an embodiment, the third extension portion E3 may be omitted.

Each of the first, second, and third extension portions E1, E2, and E3 may have a quadrangular frame shape. Each of the first, second, and third extension portions E1, E2, and E3 may include portions extending in the first direction DR1 and portions extending in the second direction DR2. In an embodiment, details of the first, second, third, and fourth areas AA1, AA2, AA3, and AA4 described with reference to FIGS. 9 to 12 may be applied to the second extension portion E2 of FIG. 13.

FIG. 14A shows the portions extending in the second direction DR2 among the first, second, and third extension portions E1, E2, and E3 as a representative example. As shown in FIG. 14A, the first extension portion E1 may have a shape bent in an area adjacent to first and second emission connection parts CE1 and CE2.

The bridge portions BP may include first bridge portions B1, second bridge portions B2, and third bridge portions B3.

Each of the first bridge portions B1 may extend from the first extension portion E1. As an example, each of the first bridge portions B1 may extend from the first extension portion E1 to the third-first extension portion E3-1 and may connect the first and third-first extension portions E1 and E3-1 to each other.

Each of the second bridge portions B2 may extend from the second extension portion E2. As an example, each of the second bridge portions B2 may extend from the second extension portion E2 to the third-second extension portion E3-2 and may connect the second and third-second extension portions E2 and E3-2 to each other.

Each of the third bridge portions B3 may connect the third extension portions E3 to each other. As an example, each of the third bridge portions B3 may extend from the third-first extension portion E3-1 to the third-second extension portion E3-2 and may connect the third-first and third-second extension portions E3-1 and E3-2 to each other.

In an embodiment, each of the bridge portions BP may have a straight line shape. Each of the bridge portions BP may extend in a direction perpendicular to an extension direction of the extension portions EP connected thereto. FIG. 14A shows the bridge portions BP extending in the first direction DR1 as a representative example.

In an embodiment, a pair of bridge portions among the first, second, and third bridge portions B1, B2, and B3 may be aligned with each other in one direction, for example, the first direction DR1.

According to an embodiment, at least a portion of the outer side surface OS included in the second extension portion E2 may include a connection area CA_OS. According to the embodiment described with reference to FIG. 9, the entire area of the outer side surface OS may be the connection area CA_OS, and according to the embodiments described with reference to FIGS. 10A to 12, the remaining area of the outer side surface OS except the connection area CA_OS may be the separation area SA_OS (refer to FIGS. 10A to 12).

Referring to FIGS. 14A and 14B, the separation conductive layer PT2' may include a first portion P1_P' overlapping the display area DA and a second portion P2_P' overlapping the peripheral area NDA. The first portion P1_P' may include a first sub-portion P11_P disposed on the inner side portion P1_S of the separator SPR' and a second sub-portion P12_P' disposed on the outer portion P2_S' of the separator SPR'. The second portion P2_P' may not overlap the separator SPR'.

In an embodiment, the second sub-portion P12_P' may be disposed on the extension portions EP and the bridge portions BP and may have an integral shape. Accordingly, the second sub-portion P12_P' may have substantially the same shape as the shape of the extension portions EP and the bridge portions BP when viewed in the plan view.

At least a portion of the second portion P2_P' may extend from the second sub-portion P12_P'. The second portion P2_P' may be electrically connected to a first power line VDL, may receive the first power supply voltage VDD (refer to FIGS. 2A and 2B), and may provide the first power supply voltage VDD (refer to FIGS. 2A and 2B) applied thereto to the first portion P1_P' through the second portion P2_P'. Accordingly, a constant voltage may be applied to the first portion P1_P', and the separation conductive layer PT2' may not be provided in a floating state on the separator SPR'. Accordingly, an electrical interference of the separation conductive layer PT2', which reaches the light emitting device LD (refer to FIG. 5A) and the sensing layer ISL (refer to FIG. 5A), may be reduced, and an electrical reliability of the light emitting device LD (refer to FIG. 5A) and the sensing layer ISL (refer to FIG. 5A) may be improved. Thus, defects in the display quality of the display panel DP' may be reduced, and thus, the sensing reliability of the display panel DP (refer to FIG. 5A) may be improved.

In an embodiment, the display panel DP' may further include the additional separation pattern layer PT-A. The additional separation pattern layer PT-A may have a pattern shape whose patterns are spaced apart from each other and may be spaced apart from the second sub-portion P12_P'. The additional separation pattern layer PT-A may be surrounded by the extension portions EP and the bridge portions BP connected to the extension portions EP.

The additional separation pattern layer PT-A may include a residue separated from the intermediate layer ML (refer to FIG. 5A) by the outer portion P2_S' of the separator SPR' when the intermediate layer ML (refer to FIG. 5A) is commonly formed. The additional separation pattern layer PT-A may further include a residue separated from the second electrodes EL2_1, EL2_2, and EL2_3 by the outer portion P2_S' when the second electrodes EL2_1, EL2_2, and EL2_3 are commonly formed.

However, the disclosure should not be limited thereto or thereby. According to an embodiment, the additional separation pattern layer PT-A may include only one of the residue separated from the intermediate layer ML (refer to FIG. 5A) and the residue separated from the second electrodes EL2_1, EL2_2, and EL2_3, and the material for the additional separation pattern layer PT-A may be changed depending on a position at which the additional separation pattern layer PT-A is formed.

According to the disclosure, as the plural extension portions EP are arranged in the peripheral area NDA, the separation conductive layer PT2' and the second electrodes EL2_1, EL2_2, and EL2_3 may be more clearly separated. Accordingly, the second electrodes EL2_1, EL2_2, and EL2_3 may be prevented from being electrically connected to the first power line VDL, and defects of the light emitting device may be prevented.

According to the disclosure, as the outer portion P2_S' may include the bridge portions BP each connecting the extension portions EP adjacent to each other, the extension portions EP may be prevented from being disconnected or bent. When the extension portion EP is patterned, multiple exposure processes may be performed, and the exposure process may be performed twice in some or a number of areas. The bridge portions BP may be disposed in the areas where the exposure process is performed twice, and the areas may be supported by the bridge portions BP although the areas are exposed twice and a thickness of the areas becomes thin. Accordingly, a process reliability of the separator SPR' may be improved, and defects of the separator SPR' may be reduced.

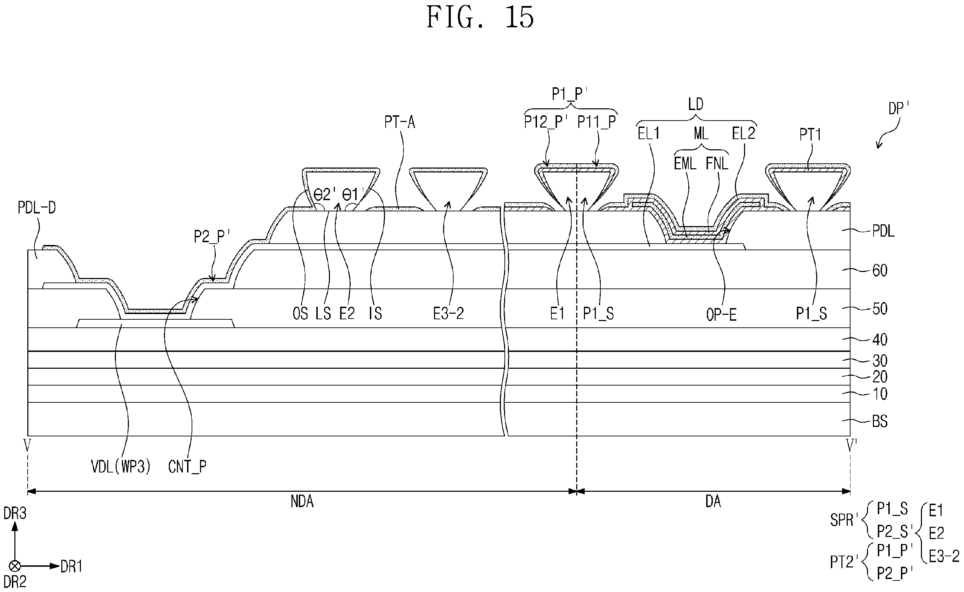

FIG. 15 is an enlarged schematic cross-sectional view of the display panel DP taken along line V-V' of FIG. 13 according to an embodiment. FIG. 15 shows a portion of the inner side portion P1_S of the separator SPR' and the first extension portion E1, the second extension portion E2, and the third-second extension portion E3-2 of the outer portion P2_S' as a representative example.

An interior angle θ2' between the outer side surface OS and a lower surface LS of the separator SPR' is smaller than an interior angle θ1' between an inner side surfaces IS and the lower surface LS of the separator SPR'. Accordingly, the second sub-portion P12_P' and the second portion P2_P' of the separation conductive layer PT2' may be connected to each other, and the first power supply voltage VDD (refer to FIGS. 2A and 2B) provided through the second portion P2_P' may be provided to the first portion P1_P'.

The connection relation in which the second portion P2_P' is electrically connected to the first power line VDL may be the same as that described with reference to FIG. 8A, however, the disclosure should not be limited thereto or thereby. According to an embodiment, the connection relation in which the second portion P2_P' is electrically connected to the first power line VDL may be the same as that described with reference to FIG. 8B.

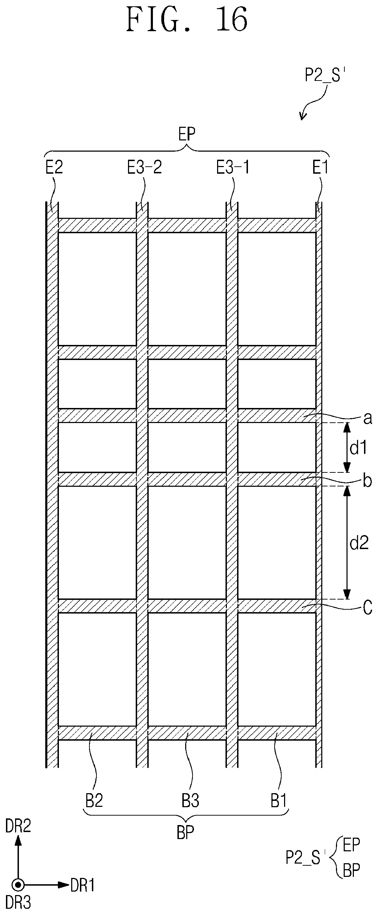

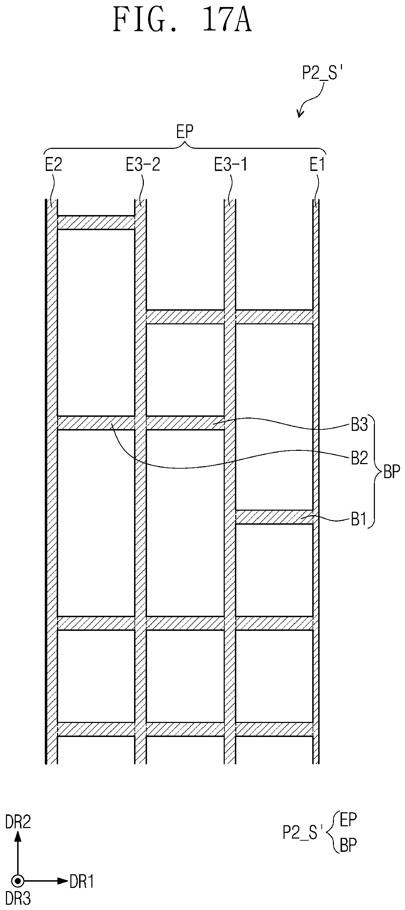

FIG. 16 is an enlarged schematic plan view of components of a display panel according to an embodiment. FIGS. 17A to 17C are enlarged schematic plan views of components of display panels according to embodiments. FIGS. 16 and 17A to 17C are enlarged views of outer portion P2_S' of the separator SPR' (refer to FIG. 14A).

Referring to FIG. 16, the outer portion P2_S' may include extension portions EP and bridge portions BP. The extension portions EP may include first, second, third-first, and third-second extension portions E1, E2, E3-1, and E3-2, and the bridge portions BP may include first, second, and third bridge portions B1, B2, and B3.

In an embodiment, each of the bridge portions BP may extend in a direction perpendicular to a direction in which the extension portions EP extend. The first bridge portion B1, the second bridge portion B2, and the third bridge portion B3, which are defined as a unit and are adjacent to each other, may be aligned with each other in the first direction DR1.

In an embodiment, separation distances between the first bridge portions B1 adjacent to each other among the first bridge portions B1 may not be the same as each other. For example, the separation distances between the first bridge portions B1 adjacent to each other may be set in various ways according to positions where the first bridge portions B1 are disposed.

As an example, the first bridge portions B1 may include first-first, first-second, and first-third bridge portions a, b, and c sequentially arranged in a direction opposite to the second direction DR2, and a separation distance d1 between the first-first and first-second bridge portions a and b may be different from a separation distance d2 between the first-second and first-third bridge portions b and c. Descriptions of the separation distance between the first bridge portions B1 may be equally applicable to the second and third bridge portions B2 and B3.

Referring to FIG. 17A, the outer portion P2_S' may include extension portions EP and bridge portions BP. The extension portions EP may include first, second, third-first, and third-second extension portions E1, E2, E3-1, and E3-2, and the bridge portions BP may include first, second, and third bridge portions B1, B2, and B3.

In an embodiment, bridge portions adjacent to each other among the first, second, and third bridge portions B1, B2, and B3 may not be aligned in the first direction DR1. As an example, only two bridge portions among the first, second, and third bridge portions B1, B2, and B3 adjacent to each other may be aligned with each other in the first direction DR1, or all the first, second, and third bridge portions B1, B2, and B3 may not be aligned with each other in one direction or in a direction.

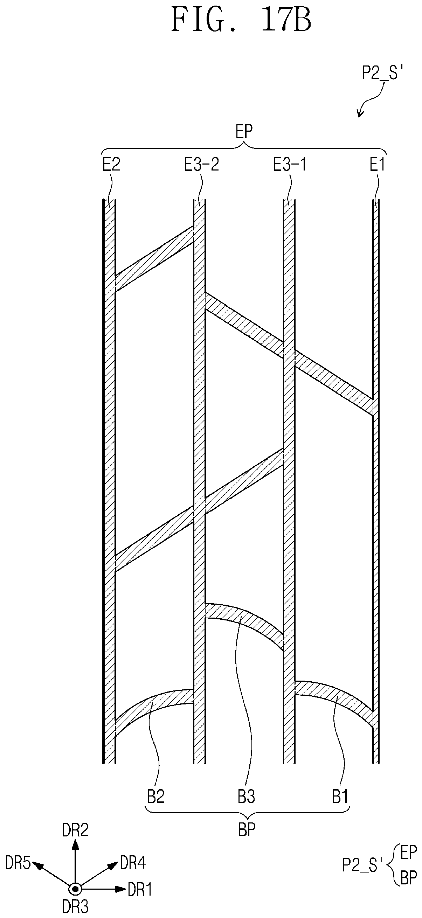

Referring to FIG. 17B, the outer portion P2_S' may include extension portions EP and bridge portions BP. The extension portions EP may include first, second, third-first, and third-second extension portions E1, E2, E3-1, and E3-2, and the bridge portions BP may include first, second, and third bridge portions B1, B2, and B3.

In an embodiment, each of the first, second, and third bridge portions B1, B2, and B3 may extend in a fourth direction DR4 corresponding to an oblique direction of the first direction DR1 or may extend in a fifth direction DR5 intersecting the fourth direction DR4. Each of the first, second, and third bridge portions B1, B2, and B3 may have a straight line shape or a curved line shape.

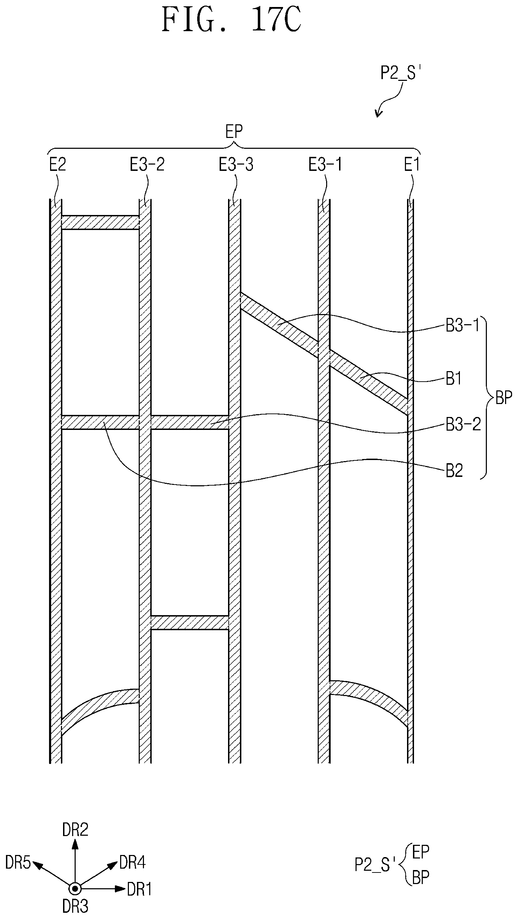

Referring to FIG. 17C, the outer portion P2_S' may include extension portions EP and bridge portions BP. The extension portions EP may include first, second, third-first, third-second, and third-third extension portions E1, E2, E3-1, E3-2, and E3-3, and the bridge portions BP may include first, second, third-first, and third-second bridge portions B1, B2, B3-1, and B3-2. For example, FIG. 17C shows three third extension portions E3 (refer to FIG. 14A).

The third-third extension portion E3-3 may be disposed between the third-first and third-second extension portions E3-1 and E3-2, the third-first bridge portion B3-1 may be disposed between the third-first and third-third extension portions E3-1 and E3-3, and the third-second bridge portion B3-2 may be disposed between the third-second and third-third extension portions E3-2 and E3-3.

In an embodiment, some or a number of the bridge portions BP may extend in a direction, for example, the first direction DR1, that is perpendicular to a direction in which the extension portions EP extend. The other of the bridge portions BP may extend in the fourth direction DR4 or the fifth direction DR5. The bridge portions BP extending in the fourth direction DR4 or the fifth direction DR5 may have a straight line shape or a curved line shape.

Although embodiments have been described, it is understood that the disclosure should not be limited to these embodiments but various changes and modifications can be made by one of ordinary skill in the art within the scope of the disclosure and as hereinafter claimed. Therefore, the disclosed subject matter should not be limited to any single embodiment described herein, and the scope of the disclosure shall be determined according to the attached claims.

The present invention can also be defined by reference to the following clauses:
Clause 1. A display panel divided into a display area and a peripheral area adjacent to the display area, wherein the display panel comprises:
   at least one transistor disposed on a base layer;
   a light emitting device comprising a first electrode and a second electrode disposed on the first electrode and electrically connected to the at least one transistor;
   a separator;
   a power line at least partially disposed in the peripheral area; and
   a separation conductive layer comprising:
      a first portion disposed on the separator; and
      a second portion disposed in the peripheral area,
   an outer side surface of the separator comprises a connection area,
   an interior angle between the connection area and a lower surface of the separator is smaller than an interior angle between an inner side surface of the separator and the lower surface of the separator, and
   the first portion disposed on the connection area is connected to the second portion.
Clause 2. The display panel of claim 1, wherein
   the second portion is electrically connected to the power line,
   the power line receives a constant voltage, and
   the first portion receives the constant voltage via the second portion.
Clause 3. The display panel of clause 1 or clause 2, wherein the second portion extends from a portion of the first portion, which is disposed on the connection area, to a direction away from the separator.
Clause 4. The display panel of any one of clauses 1 to 3, wherein the power line is electrically connected to the first electrode and provides a first power supply voltage to the first electrode.
Clause 5. The display panel of clause 4, wherein
   a portion of the power line electrically connects the first electrode, and
   another portion of the power line electrically connects the second portion of the separation conductive layer.
Clause 6. The display panel of any one of clauses 1 to 5, wherein the power line is electrically connected to the at least one transistor and provides a second power supply voltage to the at least one transistor.
Clause 7. The display panel of any one of clauses 1 to 6, wherein
   the separator comprises:
      an inner side portion disposed in the display area, and
      an outer portion surrounding the inner side portion and disposed in the peripheral area,
   the outer portion comprises:
      a first area and a second area each extending in a first direction and spaced apart from each other in a second direction intersecting the first direction; and
      a third area and a fourth area each extending in the second direction and spaced apart from each other in the first direction.
Clause 8. The display panel of clause 7, wherein the first area, the second area, the third area, and the fourth area comprise the connection area.
Clause 9. The display panel of clause 7, wherein
   the outer side surface of the separator further comprises a separation area,
   an interior angle between the separation area and the lower surface of the separator is greater than an interior angle between the connection area and the lower surface of the separator, and
   the first portion disposed on the separation area is separated from the second portion in a cross-section.
Clause 10. The display panel of clause 9, wherein
   a portion of the first area, the second area, the third area and the fourth area comprises the connection area, and
   the other portion of the first area, the second area, the third area and the fourth area comprises the separation area.
Clause 11. The display panel of clause 9, wherein
   the connection area comprises first sub-connection areas and second sub-connection areas,
   the separation area comprises a first main separation area, a second main separation area, first sub-separation areas, and second sub-separation areas,
   the third area and the fourth area comprise the first main separation area and the second main separation area, respectively,
   the first area comprises the first sub-separation areas and the first sub-connection areas alternately disposed with the first sub-separation areas, and
   the second area comprises the second sub-separation areas and the second sub-connection areas alternately disposed with the second sub-separation areas.
Clause 12. The display panel of clause 9, wherein
   the connection area comprises a main connection area, first sub-connection areas, and second sub-connection areas,
   the separation area comprises a main separation area, first sub-separation areas, and second sub-separation areas,
   the third area comprises the main connection area,
   the fourth area comprises the main separation area,
   the first area comprises the first sub-separation areas and the first sub-connection areas alternately disposed with the first sub-separation areas, and
   the second area comprises the second sub-separation areas and the second sub-connection areas alternately disposed with the second sub-separation areas.
Clause 13. The display panel of any one of clauses 1 to 12, wherein the first portion has substantially a same shape as the separator in a plan view.
Clause 14. The display panel of any one of clauses 1 to 13, wherein the interior angle between the inner side surface of the separator and the lower surface of the separator and the interior angle between the connection area and the lower surface of the separator is about equal to or greater than about 90 degrees.
Clause 15. The display panel of any one of clauses 1 to 13, wherein
   the interior angle between the inner side surface of the separator and the lower surface of the separator is about equal to or greater than about 90 degrees, and
   the interior angle between the connection area and the lower surface of the separator is less than about 90 degrees.
Clause 16. The display panel of any one of clauses 1 to 15, wherein
   the power line corresponds to one of a first power line receiving a first power supply voltage and a second power line receiving a second power supply voltage, and
   the first power line comprises:
      a first wiring part disposed at an upper side of the display area and comprising patterns disposed in a first direction;
      a second wiring part disposed at a lower side of the display area and comprising patterns disposed in the first direction;
      a third wiring part disposed at a left side of the display area and extending in a second direction intersecting the first direction; and
      a fourth wiring part disposed at a right side of the display area and extending in the second direction.
Clause 17. The display panel of clause 16, wherein the second power line comprises:
   a fifth wiring part disposed at the upper side of the display area and comprising patterns surrounding the patterns of the first wiring part, respectively; and
   a sixth wiring part disposed at the lower side of the display area and comprising patterns surrounding the patterns of the second wiring part, respectively.
Clause 18. The display panel of any one of clauses 1 to 17, further comprising:
   a connection wiring electrically connecting the transistor to the light emitting device,
   wherein the connection wiring comprises:
      an emission connection part electrically connected to the light emitting device; and
      a driver connection part electrically connected to the transistor.
Clause 19. The display panel of clause 18, wherein
   the connection wiring comprises:
      a first layer;
      a second layer disposed on the first layer; and
      a third layer disposed on the second layer,
   a side surface of the third layer protrudes outward from a side surface of the second layer, and
   the second electrode contacts the side surface of the second layer.
Clause 20. The display panel of any one of clauses 1 to 19, wherein the separation conductive layer is spaced apart from the second electrode, and the separation conductive layer and the second electrode comprise a same material.
Clause 21. The display panel of any one of clauses 1 to 20, wherein
   the separator comprises:
      an inner side portion disposed in the display area; and
      an outer portion surrounding the inner side portion and disposed in the peripheral area, and
   the outer portion comprises:
      a first extension portion surrounding the display area;
      a second extension portion surrounding the first extension portion and comprising the outer side surface; and
      bridge portions each connecting the first extension portion and the second extension portion.
Clause 22. The display panel of clause 21, wherein the second extension portion comprises:
   a first area and a second area each extending in a first direction and spaced apart from each other in a second direction intersecting the first direction; and
   a third area and a fourth area each extending in the second direction and spaced apart from each other in the first direction.
Clause 23. The display panel of clause 21 or clause 22, wherein each of the bridge portions extends in a direction perpendicular to an extension direction in which the first extension portion extends or an oblique direction of the extension direction.
Clause 24. The display panel of clause 21 or clause 22, wherein each of the bridge portions has a substantially straight line shape or a substantially curved line shape in a plan view.
Clause 25. The display panel of any one of clauses 21 to 24, wherein the outer portion further comprises:
   a third extension portion disposed between the first extension portion and the second extension portion, and
   the bridge portions comprise:
      a first bridge portion connecting the first extension portion and the third extension portion; and
      a second bridge portion connecting the second extension portion and the third extension portion.
Clause 26. The display panel of any one of clauses 21 to 25, further comprising:
   an additional separation pattern layer surrounded by the first extension portion, the second extension portion, and the bridge portions connected to the first extension portion and the second extension portion spaced apart from the separation conductive layer, and
   the additional separation pattern layer and the second electrode comprising a same material.

## Claims

1. A display panel divided into a display area and a peripheral area adjacent to the display area, wherein the display panel comprises:
at least one transistor disposed on a base layer;
a light emitting device comprising a first electrode and a second electrode disposed on the first electrode and electrically connected to the at least one transistor;
a separator;
a power line at least partially disposed in the peripheral area; and
a separation conductive layer comprising:
a first portion disposed on the separator; and
a second portion disposed in the peripheral area,
an outer side surface of the separator comprises a connection area,
an interior angle between the connection area and a lower surface of the separator is smaller than an interior angle between an inner side surface of the separator and the lower surface of the separator, and
the first portion disposed on the connection area is connected to the second portion.

2. The display panel of claim 1, wherein
the second portion is electrically connected to the power line,
the power line is configured to receive a constant voltage, and
the first portion is configured to receive the constant voltage via the second portion.

3. The display panel of claim 1 or claim 2, wherein the second portion extends from a portion of the first portion, which is disposed on the connection area, to a direction away from the separator.

4. The display panel of any one of claims 1 to 3, wherein the power line is electrically connected to the first electrode and is configured to provide a first power supply voltage to the first electrode.

5. The display panel of claim 4, wherein
a portion of the power line electrically connects the first electrode, and
another portion of the power line electrically connects the second portion of the separation conductive layer.

6. The display panel of any one of claims 1 to 5, wherein the power line is electrically connected to the at least one transistor and is configured to provide a second power supply voltage to the at least one transistor.

7. The display panel of any one of claims 1 to 6, wherein
the separator comprises:
an inner side portion disposed in the display area, and
an outer portion surrounding the inner side portion and disposed in the peripheral area,
the outer portion comprises:
a first area and a second area each extending in a first direction and spaced apart from each other in a second direction intersecting the first direction; and
a third area and a fourth area each extending in the second direction and spaced apart from each other in the first direction.

8. The display panel of claim 7, wherein:
(i) the first area, the second area, the third area, and the fourth area comprise the connection area; or
(ii) the outer side surface of the separator further comprises a separation area,
an interior angle between the separation area and the lower surface of the separator is greater than an interior angle between the connection area and the lower surface of the separator, and
the first portion disposed on the separation area is separated from the second portion in a cross-section; or
(iii) a portion of the first area, the second area, the third area and the fourth area comprises the connection area, and
the other portion of the first area, the second area, the third area and the fourth area comprises the separation area; or
(iv) the connection area comprises first sub-connection areas and second sub-connection areas,
the separation area comprises a first main separation area, a second main separation area, first sub-separation areas, and second sub-separation areas,
the third area and the fourth area comprise the first main separation area and the second main separation area, respectively,
the first area comprises the first sub-separation areas and the first sub-connection areas alternately disposed with the first sub-separation areas, and
the second area comprises the second sub-separation areas and the second sub-connection areas alternately disposed with the second sub-separation areas; or
(v) the connection area comprises a main connection area, first sub-connection areas, and second sub-connection areas,
the separation area comprises a main separation area, first sub-separation areas, and second sub-separation areas,
the third area comprises the main connection area,
the fourth area comprises the main separation area,
the first area comprises the first sub-separation areas and the first sub-connection areas alternately disposed with the first sub-separation areas, and
the second area comprises the second sub-separation areas and the second sub-connection areas alternately disposed with the second sub-separation areas.

9. The display panel of any one of claims 1 to 8, wherein the first portion has substantially a same shape as the separator in a plan view.

10. The display panel of any one of claims 1 to 9, wherein:
(i) the interior angle between the inner side surface of the separator and the lower surface of the separator and the interior angle between the connection area and the lower surface of the separator is about equal to or greater than about 90 degrees; or
(ii) the interior angle between the inner side surface of the separator and the lower surface of the separator is about equal to or greater than about 90 degrees, and
the interior angle between the connection area and the lower surface of the separator is less than about 90 degrees.

11. The display panel of any one of claims 1 to 10, wherein
the power line corresponds to one of a first power line configured to receive a first power supply voltage and a second power line configured to receive a second power supply voltage, and
the first power line comprises:
a first wiring part disposed at an upper side of the display area and comprising patterns disposed in a first direction;
a second wiring part disposed at a lower side of the display area and comprising patterns disposed in the first direction;
a third wiring part disposed at a left side of the display area and extending in a second direction intersecting the first direction; and
a fourth wiring part disposed at a right side of the display area and extending in the second direction, optionally wherein the second power line comprises:
a fifth wiring part disposed at the upper side of the display area and comprising patterns surrounding the patterns of the first wiring part, respectively; and
a sixth wiring part disposed at the lower side of the display area and comprising patterns surrounding the patterns of the second wiring part, respectively.

12. The display panel of any one of claims 1 to 11, further comprising:
a connection wiring electrically connecting the transistor to the light emitting device,
wherein the connection wiring comprises:
an emission connection part electrically connected to the light emitting device; and
a driver connection part electrically connected to the transistor, optionally wherein
the connection wiring comprises:
a first layer;
a second layer disposed on the first layer; and
a third layer disposed on the second layer,
a side surface of the third layer protrudes outward from a side surface of the second layer, and
the second electrode contacts the side surface of the second layer.

13. The display panel of any one of claims 1 to 12, wherein
the separation conductive layer is spaced apart from the second electrode, and
the separation conductive layer and the second electrode comprise a same material.

14. The display panel of any one of claims 1 to 13, wherein
the separator comprises:
an inner side portion disposed in the display area; and
an outer portion surrounding the inner side portion and disposed in the peripheral area, and
the outer portion comprises:
a first extension portion surrounding the display area;
a second extension portion surrounding the first extension portion and comprising the outer side surface; and
bridge portions each connecting the first extension portion and the second extension portion.

15. The display panel of claim 14, wherein:
(i) the second extension portion comprises:
a first area and a second area each extending in a first direction and spaced apart from each other in a second direction intersecting the first direction; and
a third area and a fourth area each extending in the second direction and spaced apart from each other in the first direction; and/or
(ii) each of the bridge portions extends in a direction perpendicular to an extension direction in which the first extension portion extends or an oblique direction of the extension direction; and/or
(iii) each of the bridge portions has a substantially straight line shape or a substantially curved line shape in a plan view; and/or
(iv) the outer portion further comprises:
a third extension portion disposed between the first extension portion and the second extension portion, and
the bridge portions comprise:
a first bridge portion connecting the first extension portion and the third extension portion; and
a second bridge portion connecting the second extension portion and the third extension portion; and/or
(v) the display panel further comprises:
an additional separation pattern layer surrounded by the first extension portion, the second extension portion, and the bridge portions connected to the first extension portion and the second extension portion spaced apart from the separation conductive layer, and
the additional separation pattern layer and the second electrode comprising a same material.
